(19) Europäisches Patentamt / European Patent Office / Office européen des brevets

(11) **EP 4 696 511 A1**

(12) **EUROPEAN PATENT APPLICATION**


(43) Date of publication:
**18.02.2026 Bulletin 2026/08**

(51) International Patent Classification (IPC):
***B41J 2/16*** *(2006.01)*

(21) Application number: **25193969.0**

(22) Date of filing: **05.08.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.08.2024 JP 2024130169**
**02.05.2025 JP 2025076583**



(71) Applicant: **Canon Kabushiki Kaisha**
**Tokyo, 146-8501 (JP)**

(72) Inventors:
- **KOBATAKE, Erika**
  **Tokyo, 146-8501 (JP)**
- **TSUTSUI, Satoshi**
  **Tokyo, 146-8501 (JP)**
- **HAMADE, Yohei**
  **Tokyo, 146-8501 (JP)**
- **ISHII, Miho**
  **Tokyo, 146-8501 (JP)**
- **SUGIMOTO, Hikaru**
  **Tokyo, 146-8501 (JP)**
- **YAMAJI, Haruka**
  **Tokyo, 146-8501 (JP)**
- **TAKAI, Yu**
  **Tokyo, 146-8501 (JP)**

(74) Representative: **TBK**
**Bavariaring 4-6**
**80336 München (DE)**


(54) **INK-JET RECORDING HEAD**


(57) An ink-jet recording head, wherein the ink-jet recording head has a silicone-containing film on a surface where a discharge port is provided, when a surface of the silicone-containing film etched in a thickness direction perpendicular to the surface of the silicone-containing film using $C60^+$ with an accelerating voltage of 40 kV applied thereto is subjected to a composition analysis by a time of flight secondary ion mass spectrometry ToF-SIMS, a value of a ratio of an abundance of $SiC_3H_9^+$ at an etching time of 30 s to an abundance of $SiC_3H_9^+$ at an outermost surface (0 s) of the silicone-containing film is 0.70 or more, and a contact angle at the outermost surface of the silicone-containing film is 80° or more.


Fig. 1A

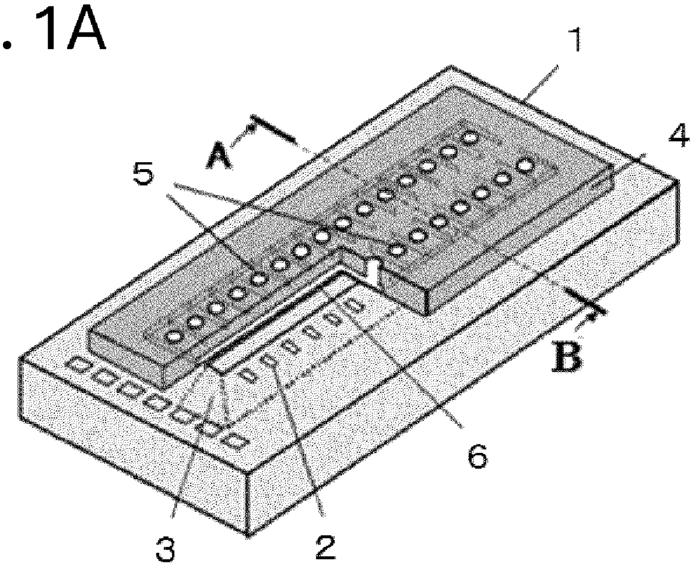





EP 4 696 511 A1

## Description

### TECHNICAL FIELD

The present disclosure relates to an ink-jet recording head.

### BACKGROUND

In general, fluorine-based water-repellent materials are known as materials for forming liquid-repellent and antifouling films, and particularly compounds having a perfluoroalkyl group or a perfluoropolyether group have excellent liquid-repellency and durability, and are widely used in various applications. However, since fluorine-containing compounds have high chemical stability and are resistant to decomposition, in a case where the discharge to the environment continues, the fluorine-containing compounds remain in the environment for a long period of time, and there is a possibility of affecting human health, and the habitat and growth of animals and plants through the environment and food chain. Therefore, in recent years, in order to achieve a sustainable society such as a circulatory society, conversion from fluorine-based water-repellent materials to non-fluorine-based water-repellent materials has been desired.

A silicone compound exhibits excellent liquid-repellency even though it is a fluorine-free water-repellent material, and can be used as a substitute for a fluorine-based water-repellent material. Silicone compounds can eliminate concerns regarding environmental impact, fluorine sources, and the like.

For example, Japanese Patent Application Publication No. 2001-158818 discloses a technique using a silicone compound, particularly a siloxane-containing epoxy resin composition, as a non-fluorine-based water-repellent material.

### SUMMARY

Water-repellent materials such as fluorine-based or silicone-based materials may exhibit water-repellency by segregating water-repellent groups on a surface of a water-repellent film. As disclosed in Japanese Patent Application Publication No. 2001-158818, in a comb-shaped water-repellent structure, there is a large degree of freedom in silicone, and a siloxane main chain is segregated on a surface when a film is formed. For this reason, durability may not be sufficient, and for example, blade wipe durability suitable for commercial and industrial printing may not be able to achieve.

Accordingly, the present disclosure provides an ink-jet recording head that is superior in blade wipe durability suitable for commercial and industrial printing.

The present disclosure in its first aspect provides an ink-jet recording head as specified in claim 1. Optional features are specified in claims 2 to 10.

The present disclosure can provide an ink-jet recording head that is superior in blade wipe durability suitable for commercial and industrial printing.

Features of the present disclosure will become apparent from the following description of embodiments with reference to the attached drawings. The following description of embodiments are described by way of example.

### BRIEF DESCRIPTION OF THE DRAWINGS

FIGS. 1A and 1B are schematic views of an ink-jet recording head using a silicone-containing film;
FIGS. 2A to 2H are views for explaining an example of a method of manufacturing an ink-jet recording head using a silicone-containing film;
FIGS. 3A and 3B are views for explaining a procedure of forming a silicone-containing film;
FIGS. 4A and 4B are schematic views of an ink-jet recording head using a silicone-containing film;
FIGS. 5A to 5D are schematic views showing a method of forming a water-repellent film on a discharge port; and
FIG. 6 is a graph showing a count number of each ion depending on etching time.

### DESCRIPTION OF THE EMBODIMENTS

In the present disclosure, the description of "from XX to YY" and "XX to YY" representing a numerical range means a numerical range including the lower limit and the upper limit which are endpoints, unless specified otherwise. When the numerical ranges are described in stages, the upper limits and lower limits of respective numerical ranges can be combined arbitrarily. Also, in the present disclosure, for example, the description such as "at least one selected from the group consisting of XX, YY and ZZ" means any of XX, YY, ZZ, a combination of XX and YY, a combination of XX and ZZ, a combination of YY and ZZ, or a combination of XX, YY and ZZ. When XX is a group, a plurality of constituents may be

selected from XX, and the same applies to YY and ZZ.

Hereinafter, embodiments of the present disclosure will be described, but the present disclosure is not limited only to these embodiments. In addition, not all combinations of features described in the present embodiment are essential to the solution of the present disclosure. The constituent elements described in the embodiments are merely examples, and the scope of the present disclosure is not intended to be limited only thereto.

A film superior in blade wipe durability can be formed by using a specific silicone-containing film on a surface of an ink-jet recording head where a discharge port is provided. The silicone-containing film can be used as a water- and oil-repellent film. The silicone-containing film will be described below.

Alkylsiloxane Resin

Etching is performed in a thickness direction perpendicular to a surface of a silicone-containing film under the following etching conditions, and a composition analysis by a time of flight secondary ion mass spectrometry ToF-SIMS is performed. In this case, a value of a ratio of an abundance of $SiC_3H_9^+$ at an etching time of 30 s to an abundance of $SiC_3H_9^+$ at an outermost surface (0 s) of the silicone-containing film (hereinafter, simply referred to as a "value of a ratio of $SiC_3H_9^+$") is 0.70 or more.

Etching Conditions

Etching is performed every 30 s using $C_{60}^+$ with an output of $C_{60}^+$ of 40 kV.

The Time of Flight Secondary Ion Mass Spectrometry (ToF-SIMS) is a surface analysis method that performs qualitative analysis of elements and molecules on extreme surfaces (up to 2 nm) of various materials. In this analysis method, fragment ions of a polymer produced by a polymerization reaction of a silicone compound are detected. Therefore, even when an end of the silicone resin does not have a structure of $Si(CH_3)_3$, $SiC_3H_9^+$ is generated during measurement.

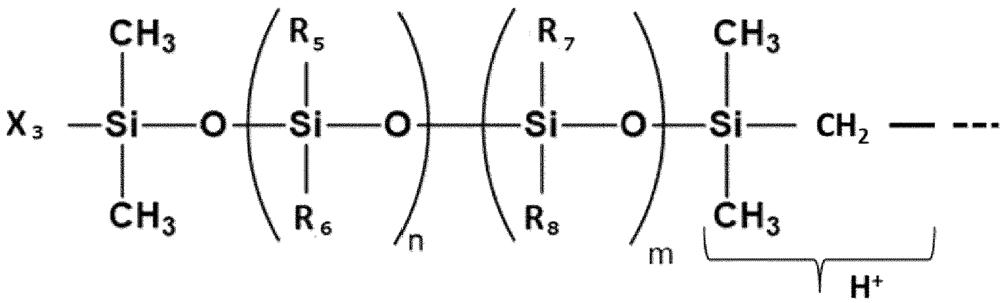


Therefore, the peak intensity of $SiC_3H_9^+$ in the measurement spectrum obtained by ToF-SIMS is primarily derived from the silicone resin. Accordingly, a peak intensity ratio of the $SiC_3H_9^+$ before and after the surface of the silicone-containing film is etched can be used as an index representing a distribution of the silicone resin in the depth direction of the silicone-containing film.

In the etching for 30 seconds under the above-described etching conditions, the cutting depth is about 60 nm. Accordingly, it is considered that the value of the ratio of $SiC_3H_9^+$ of 0.70 or more indicates that the silicone resin is uniformly present in a certain range in the depth direction of the silicone-containing film. Therefore, superior blade wipe durability can be obtained.

On the other hand, when the value of the ratio of $SiC_3H_9^+$ is below 0.70, it means that the silicone resin is segregated on and near the surface of the silicone-containing film. Therefore, the silicone resin is likely to degrade in the blade wipe test. As a result, the degradation of the silicone resin results in a decrease in liquid repellency.

The value of the ratio of $SiC_3H_9^+$ is preferably 0.80 or more, and more preferably 0.85 or more. The value of the ratio of $SiC_3H_9^+$ is, for example, from 0.70 to 1.00, preferably from 0.80 to 0.98, and more preferably from 0.85 to 0.97.

The value of the ratio of $SiC_3H_9^+$ is affected by the structure of the silicone compound. Silicone has low surface free energy and is likely to segregate on a surface (air interface). Depending on a structure of a silicone compound, a length of a silicone main chain, and the like, the degree of freedom of the silicone main chain varies, which affects the ease of segregation to the surface (air interface). When a silicone compound has an epoxy group at one end, the silicone main chain has a high degree of freedom and tends to be easily segregated to the surface (air interface).

On the other hand, when the silicone compound has epoxy groups at both ends, it is considered that the silicone has a low degree of freedom and the siloxane main chain is less likely to be segregated to the surface. Therefore, the

silicone main chain is fixed and the silicone tends to be distributed uniformly in a film. Therefore, from the viewpoint of setting the value of the ratio of $SiC_3H_9^+$ to 0.70 or more, it is preferable to use a material having epoxy groups at both ends of the silicone compound.

It is also effective to use an epoxy resin as a resin composition used for forming a silicone-containing film. For example, even when the silicone compound has an epoxy group in a side chain thereof, the silicone compound is firmly bonded to the epoxy resin by reaction with the epoxy resin by using the epoxy resin. Therefore, it is considered that the silicone has a low degree of freedom and a siloxane main chain is less likely to be segregated to the surface, and the value of the ratio of $SiC_3H_9^+$ is likely to be 0.70 or more. An alicyclic epoxy resin is preferably used as the epoxy resin from the viewpoint of forming a strong bond.

On the other hand, even when the silicone compound has epoxy groups at both ends, it is considered that the silicone compound may be segregated to the surface if a material that is hard to bond firmly is used.

The silicone-containing film is preferably a cured product of a resin composition containing a silicone compound. The resin composition is, for example, a photosensitive resin composition. The silicone compound is preferably an alkylsiloxane resin having a structure represented by Formula (1) below.

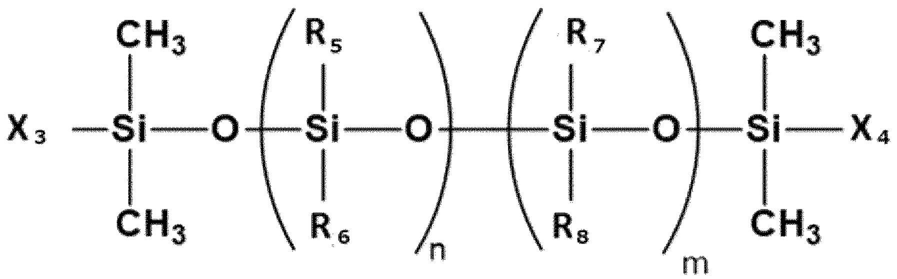

(1)

(In Formula (1), $R_5$ and $R_6$ are each independently an alkyl group having 1 to 12 carbon atoms or an aryl group having 6 to 12 carbon atoms, and at least two of $R_7$, $R_8$, $X_3$, and $X_4$ are each independently an epoxy-containing group, the others are each independently an alkyl group having 1 to 12 carbon atoms or an aryl group having 6 to 12 carbon atoms, and n + m is an integer of 1 to 60. An arrangement of the structures of parentheses with m and the structures of parentheses with n may be random or block.)

Examples of the epoxy-containing groups include groups having a glycidyl ether group or groups having an alicyclic epoxy group. The epoxy-containing group is preferably a group having a glycidyl ether group or a group having an epoxycyclohexyl group.

The epoxy-containing group is more preferably a glycidoxyalkyl group having an alkyl chain with 1 to 4 (preferably 2 to 4) carbon atoms, or an epoxycyclohexylalkyl group having an alkyl chain with 1 to 8 (preferably 2 to 6) carbon atoms. The epoxy-containing group is more preferably a 3-glycidoxyalkyl group having an alkyl chain with 1 to 4 (preferably 2 to 4) carbon atoms or a 2-(3,4-epoxycyclohexyl)alkyl group having an alkyl chain with 1 to 8 (preferably 2 to 6) carbon atoms.

Further preferable examples of the epoxy-containing group include a 3-glycidoxypropyl group, a 2-(3,4-epoxycyclohexyl)ethyl group, and a 2-(3,4-epoxycyclohexyl)pentyl group. The epoxy-containing group is even more preferably a 2-(3,4-epoxycyclohexyl)ethyl group. In particular, the epoxycyclohexylalkyl group is excellent in reactivity and can obtain high liquid-repellency.

As the alkyl group having 1 to 12 carbon atoms in Formula (1), an alkyl group having 1 to 4 carbon atoms such as a methyl group, an ethyl group, a propyl group, or a butyl group is particularly preferable. From the viewpoint of compatibility with a resin and film strength, a phenyl group or the like may be present as an aryl group having 6 to 12 carbon atoms in Formula (1).

In Formula (1), two of $R_7$, $R_8$, $X_3$, and $X_4$ are preferably epoxy-containing groups. $X_3$ and $X_4$ are epoxy-containing groups, and $R_7$ and $R_8$ are each independently an alkyl group having 1 to 12 carbon atoms or an aryl group having 6 to 12 carbon atoms.

In Formula (1), m + n is 1 to 60 from the viewpoint of compatibility with a resin and solubility in a solvent, and is preferably 10 to 60. From the viewpoint of liquid repellency, m + n is more preferably from 30 to 60. m + n may be from 20 to 60 and may also be from 25 to 45.

m in Formula (1) is preferably 0 or 1. Further, an arrangement of the structures of parentheses with m and the structures of parentheses with n may be random or block. The arrangement of the structures of parentheses with m and the structures of parentheses with n is preferably random.

In the present disclosure, by adjusting the value of the ratio of $SiC_3H_9^+$, it is possible to distribute the silicone compound uniformly in the depth direction, thus exhibiting high durability during printing.

Further, a silane coupling agent may be added to the silicone compound for the purpose of increasing the adhesiveness to an underlying film such as an inorganic film. The silicone-containing film may be, for example, a laminate

having a silicone-containing film (a layer containing silicone) on a base material. In this case, the etching may be performed from the surface of the silicone-containing film toward the base material side.

A contact angle at the outermost surface of the silicone-containing film is 80° or more. The contact angle is preferably 85° or more. A contact angle of 80° or more allows good water repellency to be exhibited. The contact angle at the outermost surface of the silicone-containing film is a value of a dynamic receding contact angle $\theta\gamma$ to pure water on the outermost surface of the silicone-containing film, measured using a micro contact angle meter ("DropMeasure" (trade name) manufactured by MICROJET).

The contact angle at the outermost surface of the silicone-containing film is, for example, from 80° to 99°, preferably from 85° to 98°, and more preferably from 87° to 97°.

The thickness of the silicone-containing film is not particularly limited because good water repellency and blade wipe resistance are obtained as long as it can endure cutting with etching for 30 seconds. The thickness of the silicone-containing film is, for example, from 0.1 to 100 $\mu$m, preferably from 0.1 to 10 $\mu$m, and more preferably from 0.2 to 2.0 $\mu$m.

Epoxy Resin

The silicone-containing film preferably includes an epoxy resin. The silicone-containing film may be a cured product of a resin composition including an epoxy resin and a silicone compound. The silicone-containing film includes, for example, an epoxy resin as a binder.

The epoxy resin is preferably a cationic polymerization type epoxy resin, and can be selected in consideration of the adhesion performance, mechanical strength, and swelling resistance of a cured product of the resin composition. The epoxy resin is, for example, a resin different from the alkylsiloxane resin having the structure represented by Formula (1) described above.

The epoxy resin is preferably at least one selected from the group consisting of an epoxy resin having an alicyclic skeleton, an epoxy resin having a bisphenol skeleton, an epoxy resin having a phenol novolac skeleton, an epoxy resin having a cresol novolac skeleton, an epoxy resin having a norbornene skeleton, an epoxy resin having a terpene skeleton, an epoxy resin having a dicyclopentadiene skeleton, and an epoxy resin having an oxycyclohexane skeleton.

More specifically, examples thereof may include cationic polymerization type epoxy resins, such as polyfunctional epoxy resins, including an epoxy resin having an alicyclic skeleton such as a cyclohexane skeleton, an epoxy resin having a bisphenol skeleton such as a bisphenol A-type and F-type epoxy resins, an epoxy resin having a phenol novolac skeleton such as a phenol novolac-type epoxy resin, an epoxy resin having a cresol novolac skeleton such as a cresol novolac-type epoxy resin, an epoxy resin having a norbornene skeleton, an epoxy resin having a terpene skeleton, an epoxy resin having a dicyclopentadiene skeleton, an epoxy resin having an oxycyclohexane skeleton, and the like. These can be used singly or in combination of one or two or more kinds thereof.

The epoxy resin further preferably includes an alicyclic epoxy resin. The alicyclic epoxy resin has good reactivity with a cationic catalyst and can make the crosslinking density of a cured product higher than that of other epoxy resins. Also, the epoxy resin preferably has no benzene ring.

The epoxy equivalent of the epoxy resin is preferably 300 g/eq. or less. The epoxy equivalent is preferably from 100 to 300 g/eq., more preferably from 100 to 230 g/eq., and still more preferably from 100 to 200 g/eq. In another preferred embodiment, the epoxy equivalent is from 160 to 230 g/eq. When the epoxy equivalent is 300 g/eq. or less, it is superior in reactivity with a silicone compound, and thus is superior in wipe durability.

The epoxy equivalent is defined by (molecular weight of epoxy resin/number of epoxy groups in one molecule of epoxy resin).

By using an epoxy resin having two or more epoxy groups, the cured product undergoes three-dimensional cross-linking, and desired curability can be obtained. It is more suitable to use an epoxy resin having three or more epoxy group. Further, at least one bifunctional epoxy resin may be added to a tri-or higher functional epoxy resin and used.

Examples of commercially available tri- or higher functional epoxy resins include "jER157S70" and "jER1031S" (trade name) manufactured by Mitsubishi Chemical Corporation, "EPICLON N-695" and "EPICLON N-865" (trade name) manufactured by Dainippon Ink and Chemicals, Inc., "CELLOXIDE 2021", "GT-300 series", "GT-400 series", and "EHPE3150" (trade name) manufactured by Daicel Corporation, "SU8" (trade name) manufactured by Nippon Kayaku, "VG3101" and "EPOX-MKR1710" manufactured by Printec Corporation, and "DENACOL series" manufactured by Nagase ChemteX Corporation.

Examples of commercially available bifunctional epoxy resins include "jER1004", "jER1007", "jER1009", "jER1010", and "jER1256" (trade name) manufactured by Mitsubishi Chemical Corporation, and "EPICLON 4050" and "EPICLON 7050" (trade name) manufactured by Dainippon Ink and Chemicals, Inc..

From the viewpoint of setting the value of the ratio of $SiC_3H_9$ to 0.70 or more, it is preferable to use a resin such as EHPE3150 which does not have a structure in which an epoxy group is directly introduced into an alicyclic skeleton to reduce the influence of steric hindrance.

The content of the silicone compound in the resin composition containing the epoxy resin and the silicone

compound (preferably an alkylsiloxane resin having a structure represented by Formula (1)) which are capable of forming the silicone-containing film is, for example, from 0.1 to 10.0 parts by mass, from 0.2 to 5.0 parts by mass, from 0.3 to 2.0 parts by mass, and from 0.5 to 1.5 parts by mass based on 100 parts by mass of the epoxy resin.

Curing Agent

The resin composition may contain a phenolic compound or a polyol having at least two hydroxyl groups as a curing promoter. The addition of these compounds is effective in promoting the cationic polymerization reaction of the epoxy resin.

Specific examples of the phenolic compounds include cardanol, terpene diphenol, and derivatives thereof. For example, there are cardanol compounds such as cardanol and cardanol derivatives. Examples of the cardanol derivatives include the induction margin of cardanol where -OH is epoxy-modified. Examples of commercially available can include "Cardolite NX-2026", "Cardolite NC-510", "Cardolite LITE2020", "Cardolite Ultra LITE 513" manufactured by Cardolite.

When the polyol has one hydroxyl group, the effect of promoting the cationic polymerization reaction of the epoxy resin is small, and thus it is preferable to have two or more hydroxyl groups. Also, the polyol preferably has a number average molecular weight of 3000 or less from the viewpoint of solubility in resins and solvents and reactivity. Further, it is preferable that a number average molecular weight is 200 or more or a boiling point is 200°C or higher in order to prevent polyol from being lost in the heating step. The number average molecular weight can be calculated in terms of polystyrene by a known method using gel permeation chromatography (for example, manufactured by Shimadzu Corporation).

Specific examples of polyols include polyethylene glycols (200, 300, 400, 600, 1000, 2000) commercially available from each company. Also, the polyether polyol may include "Adekapolyether P series", "BPX series", "G series", "SP series", "SC series", "CM series", "AM series", "EM series", "BM series", "PR series", and "GR series", manufactured by ADEKA.

The polyol may be a low molecular weight polyhydric alcohol. Examples of the low molecular weight polyhydric alcohol may include 1,2- or 1,6-hexandiol, glycerin, trimethylol propane, 3-methyl-1,5-pentanediol, 3-methyl-1,5-pentanediol, 1,2,6-hexanetriol, 1,5-dihydroxypentan-3-one, 6-hydroxycaproic acid, and 2-hydroxymethyl-1,3-propanediol. At least one of these can be used.

Coating Solvent

When the resin composition is applied as a solution, a polar organic solvent is preferably used as a coating solvent from the viewpoint of solubility. Specifically, examples thereof include polar solvents such as alcohols, ketones, ethyl acetate, butyl acetate, esters such as propylene glycol monomethyl ether acetate (PGMEA), ethers such as diglyme, tetrahydrofuran, PGME, and glycols such as diethylene glycol. Examples of alcohols include methanol, ethanol, propanol, isopropanol, and butanol, and examples of ketones include methyl ethyl ketone and methyl isobutyl ketone.

Photopolymerization Initiator

The resin composition may be a photosensitive resin composition containing a photopolymerization initiator. When the photosensitive resin composition is applied onto a base material by a photopolymerization initiator and cured, it is made into a cured product by light irradiation, thereby forming a silicone-containing film that is a liquid-repellent and anti-fouling film. In this case, liquid repellency and mechanical strength are remarkably improved as compared with heat curing, and further fine processing by patterning is possible. The photopolymerization initiator preferably allows cationic polymerization.

Examples of the photopolymerization initiator include a sulfonic acid compound, a diazomethane compound, a sulfonium salt compound, an iodonium salt compound, and disulfone-based compounds.

As the photopolymerization initiator, a photocationic polymerization initiator that can be cured at a low temperature and has a high catalytic function can be suitably used. As a specific photocationic polymerization initiator, an ionic acid generator can be selected. For the cationic moiety, an onium system with high absorption can be selected, and oxonium, ammonium, phosphonium, sulfonium, onium ions such as iodonium can be selected. Among these, sulfonium having high i-line (wavelength 365 nm) absorption and excellent cationic polymerization performance and cross-linking reaction performance is more preferable.

Specific examples of sulfonium-based cation ions include triaryl sulfonium such as triphenylsulfonium, tri-p-tolylsulfonium, tri-o-tolylsulfonium, tris(4-methoxyphenyl)sulfonium, 1-naphthyldiphenylsulfonium, 2-naphthyldiphenylsulfonium, tris(4-fluorophenyl)sulfonium, tri(1-naphthyl)sulfonium, tri(2-naphthyl)sulfonium, tris(4-hydroxyphenyl)sulfonium, 4-(phenylthio)phenyldiphenylsulfonium, 4-(p-tolylthio)phenyldi-p-tolylsulfonium, 4-(4-methoxyphenylthio)phenylbis(4-methoxyphenyl)sulfonium, 4-(phenylthio)phenylbis(4-fluorophenyl)sulfonium, 4-(phenylthio)phenylbis(4-methoxyphenyl)sulfonium, 4-(phenylthio)phenyldi-p-tolylsulfonium, [4-(4-biphenylylthio)phenyl]-4-biphenylylphenylsulfonium,

[4-(2-thioxanthonylthio)phenyl]diphenylsulfonium, bis[4-(diphenylsulfonio)phenyl]sulfide, bis[4-{bis(4-(2-hydroxyethoxy)phenyl]sulfonio}phenyl]sulfide, bis{4-[bis(4-fluorophenyl)sulfonio]phenyl}sulfide, bis{4-[bis(4-methylphenyl) sulfonio]phenyl}sulfide, bis{4-[bis(4-methoxyphenyl)sulfonio]phenyl}sulfide, 4-(4-benzoyl-2-chlorophenylthio)phenylbis(4-fluorophenyl)sulfonium, 4-(4-benzoyl-2-chlorophenylthio)phenyldiphenylsulfonium, 4-(4-benzoylphenylthio)phenylbis(4-fluorophenyl)sulfonium, 4-(4-benzoylphenylthio)phenyldiphenylsulfonium, 7-isopropyl-9-oxo-10-thia-9,10-dihydroanthracen-2-yldi-p-tolylsulfonium, 7-isopropyl-9-oxo-10-thia-9,10-dihydroanthracen-2-yldiphenylsulfonium, 2-[(di-p-tolyl)sulfonio]thioxanthone, 2-[(diphenyl)sulfonio]thioxanthone, 4-(9-oxo-9H-thioxanthen-2-yl)thiophenyl-9-oxo-9H-thioxanthen-2-yl phenylsulfonium, 4-[4-(4-tert-butylbenzoyl)phenylthio]phenyldi-p-tolylsulfonium, 4-[4-(4-tert-butylbenzoyl)phenylthio]phenyldiphenylsulfonium, 4-[4-(benzoylphenylthio)]phenyldi-p-tolylsulfonium, 4-[4-(benzoylphenylthio)]phenyldiphenylsulfonium, 5-(4-methoxyphenyl)thiaanthrenium, 5-phenylthiaanthrenium, 5-tolylthiaanthrenium, 5-(4-ethoxyphenyl)thiaanthrenium, and 5-(2,4,6-trimethylphenyl)thiaanthrenium; diaryl sulfoniums such as diphenylphenacylsulfonium, diphenyl-4-nitrophenacylsulfonium, diphenylbenzylsulfonium, and diphenylmethylsulfonium; monoaryl sulfoniums such as phenylmethylbenzylsulfonium, 4-hydroxyphenylmethylbenzylsulfonium, 4-methoxyphenylmethylbenzylsulfonium, 4-(acetylcarbonyloxy)phenylmethylbenzylsulfonium, 4-hydroxyphenylmethyl-1-naphthylmethylsulfonium, 4-hydroxyphenyl(2-naphthylmethyl)methylsulfonium, 2-naphthylmethylbenzylsulfonium, 2-naphthylmethyl(1-ethoxycarbonyl)ethylsulfonium, phenylmethylphenacylsulfonium, 4-hydroxyphenylmethylphenacylsulfonium, 4-methoxyphenylmethylphenacylsulfonium, 4-(acetylcarbonyloxy)phenylmethylphenacylsulfonium, 2-naphthylmethylphenacylsulfonium, 2-naphthyloctadecylphenacylsulfonium, and 9-anthrylmethylphenacylsulfonium; and trialkyl sulfonium such as dimethylphenacyl sulfonium, phenacyl tetrahydrothiophenium, dimethylbenzyl sulfonium, benzyltetrahydrothiophenium, and octadecylmethylphenacyl sulfonium.

A molar extinction coefficient of the photopolymerization initiator at 365 nm wavelength is 400 $M^{-1}$ $cm^{-1}$ or more. Since the molar extinction coefficient is 400 $M^{-1}$ $cm^{-1}$ or more, crosslinking density does not decrease during curing reaction, and water-repellency development and photo-patterning properties can be imparted.

The method for measuring the molar extinction coefficient of a compound such as a photopolymerization initiator is as follows. The compound of interest is dissolved in a solvent that does not have absorption at 365 nm, such as acetonitrile, to form a solution, charged into a cell made of quartz, and the absorbance at 365 nm is measured using an ultraviolet visible near-infrared spectrophotometer (manufactured by Japan Spectrometry). The molar extinction coefficient can be calculated from the absorbance obtained by the following equation.

Molar absorbance coefficient = Absorbance/Molar concentration of

Compound/Optical path of cell

The anion part can be selected from a borate type, a phosphorus type, an antimony type, and a gallate type having high acid strength, and is preferably at least one selected from the group consisting of a gallate type anion and a borate type anion. Among these, tetrakis(pentafluorophenyl) borate ions, trifluortris(pentafluoroethyl) phosphate ions, hexafluoroantimonate ions, and tetrakis(pentafluorophenyl) gallate ions are more preferred, which are excellent in cationic polymerization performance and crosslinking reaction performance. As a result, water-repellent expression and photo-patterning properties can be imparted to the same reason as for the selection of cations.

Examples of the suitably usable photopolymerization initiator described above include "ADEKAARKLS SP-170", "ADEKAARKLS SP-172", and "ADEKAARKLS SP-150" (all trade names) manufactured by ADEKA, "BBI-103" and "BBI-102" (both trade names) manufactured by Midori Kagaku Co., Ltd. In addition, "IBPF", "IBCF", "TS-01", "TS-91" (all trade names) manufactured by SANWA CHEMICAL CO., LTD., and "CPI-410S", "CR-C1", "CPI-410B", "CPI-310B", and "CPI-310FG", "ES-1B", "VC-1FG", and "CPI-101A" (all trade names) manufactured by San-Apro Ltd. Further, the composition may contain a basic substance such as amines, a photosensitizer such as an anthracene derivative, a silane coupling agent, and the like for the purpose of improving the photo-lithography performance, adhesion performance, and the like.

The content of the photopolymerization initiator can be varied as appropriate and is not particularly limited depending on the resin used. The addition amount of the photopolymerization initiator is preferably in the range of 0.5 to 5 parts by mass, more preferably in the range of 1.0 to 4.0 parts by mass, based on 100 parts by mass of the resin (preferably epoxy resin) contained in the photosensitive resin composition.

Base Material

The silicone-containing film can be used as a liquid-repellent and anti-fouling film. The silicone-containing film can be used as a liquid-repellent and anti-fouling film for liquid ejection heads, such as an ink-jet recording head. The base material forming the silicone-containing film is, for example, a surface where a discharge port is provided. A silicone-containing film may be further provided at a position other than the surface of the liquid ejection head where the discharge

port is provided. The material of the surface where the discharge ports is provided as the base material and the other members of the liquid ejection head are not particularly limited, and can be selected mainly from inorganic substrates and resin compositions.

Examples of the inorganic substrate include Si, $SiO_2$, SiOC, SiC, SiCN, Ta, TaO, and $Al_2O_3$.

As the resin composition, a negative type epoxy resin composition containing a polyfunctional epoxy resin as a main agent is used. Specific examples thereof include a bisphenol A epoxy resin, a bisphenol E epoxy resin, a bisphenol F epoxy resin, a novolac epoxy resin, a cresol novolac epoxy resin, and an alicyclic epoxy resin.

Examples of commercially available epoxy resins include "157S70" and "jER1031S" (both trade name) manufactured by Mitsubishi Chemical Corporation, and "EPICLON N-695" and "EPICLON N-865" (both trade name) manufactured by DIC Corporation. Other examples thereof include "CELLOXIDE 2021", "GT-300 series", "GT-400 series", and "EHPE3150" (all trade names) manufactured by Daicel Corporation, "SU8" (trade name) manufactured by Nippon Kayaku, "VG3101" and "EPOX-MKR1710" (both trade names) manufactured by Printec Corporation, and "DENACOL series" manufactured by Nagase ChemteX Corporation.

As an example of the application of the silicone-containing film, a method of manufacturing an ink-jet recording head using a silicone-containing film as a liquid-repellent and anti-fouling film will be described below with reference to the figures. Note that the scope of application of the silicone-containing film according to the present disclosure is not limited thereto.

Method of Manufacturing Recording Head

Recording Head Using Resin Composition on Base Material

FIG. 1A is a schematic view showing an example of an ink-jet recording head. FIG. 1B is a cross-sectional view of the recording head taken along line A-B in FIG. 1A and viewed in a cross-section perpendicular to a substrate 1.

The recording head shown in FIGS. 1A and 1B has the substrate 1 on which energy generating elements 2 for generating energy utilized for discharging liquid are formed side by side in two rows at a predetermined pitch. In the substrate 1, a liquid feeding port 3 is opened between the two rows of energy generating elements 2. On the substrate 1, discharge ports 5 provided at positions facing the energy generating elements 2 are formed by a discharge port forming member 4.

The shape of the discharge port 5 may be a so-called tapered shape in which an area of a cross section parallel to the substrate 1 decreases as it goes from the substrate 1 side to the discharge port 5. The discharge port forming member 4 includes a side wall 8 forming an individual flow path 6 communicating with each discharge port 5 from the feeding port 3, and a top plate 9 where the discharge ports 5 are opened. The discharge port forming member 4 may have a side wall 8 and the top plate 9 integrated.

A liquid-repellent and anti-fouling film (liquid-repellent layer) 7 is provided on the discharge port forming member. For example, the ink-jet recording head has a silicone-containing film (a liquid-repellent and anti-fouling film 7) on the surface where the discharge ports are provided. The liquid-repellent and anti-fouling film 7 prevents ink discharged from the discharge port 5 from sticking to the surface of the recording head. The substrate 1 functions as a part of a member constituting a flow path 6, and if it can function as a support for the discharge port forming member 4, a shape, materials, and the like of the substrate 1 are not particularly limited. In the present embodiment, a silicon substrate is used as the substrate 1 because it is easy to process.

The recording head is disposed so that a surface where the discharge port 5 opens faces a recording surface of the recording medium. Energy generated by the energy generating element 2 is applied to an ink filled in the flow path 6 via the feeding port 3, ink droplets are discharged from the discharge port 5, and the ink droplets are adhered to a recording medium to perform recording. As the energy generating element 2, an electrothermal conversion element (so-called heater) or the like can be used as an element that generates energy by heat, and a piezoelectric element or the like can be used as an element that generates energy mechanically.

The liquid-repellent and anti-fouling film 7 is a cured product of a resin composition. Specifically, regarding the liquid-repellent and anti-fouling film 7, a liquid-repellent and anti-fouling film can be formed as a cured product by applying a solution containing a resin composition and curing a coating film of the solution.

Nest, an example of a method of manufacturing an ink-jet recording head will be described with reference to FIGS. 2A to 2H. In the ink-jet recording head, components other than the liquid-repellent and anti-fouling film 7 may be those known in the art.

FIGS. 2A to 2H are schematic cross-sectional views showing an example of the method of manufacturing an ink-jet recording head according to steps, a position of the cross-section is the same as in FIG. 1B.

First, as shown in FIG. 2A, the substrate 1 having a surface where an energy generating element 2 is provided is prepared. The energy generating element 2 is connected to a control signal input electrode (not shown) for operating the element. Further, various functional layers may be provided, such as a protective layer (not shown) for the purpose of

improving the durability of the energy generating element 2 and an adhesion improving layer (not shown) for the purpose of improving the adhesiveness between the discharge port forming member 4 and the substrate 1.

Next, as shown in FIG. 2B, an ink feeding port 3 is formed through the substrate 1. The feeding port 3 can be formed by wet etching with an alkaline-based etchant such as tetramethylammonium hydroxide (TMAH) or dry etching such as reactive ion etching.

Next, as shown in FIG. 2C, a first photosensitive resin layer 10 containing a photosensitive resin and a photopolymerization initiator is formed on the substrate 1 containing the energy generating elements 2. The first photosensitive resin layer 10 is a so-called negative type photosensitive resin layer. The first photosensitive resin layer 10 is preferably formed by applying a photosensitive resin to a film base material made of PET or polyimide and transferring the photosensitive resin onto the substrate 1 using a laminate method. Since the photosensitive resin included in the first photosensitive resin layer 10 satisfies various performances such as high mechanical strength, adhesiveness to an underlying layer, ink resistance, and resolution for patterning a fine pattern of the discharge port 5, epoxy resins can be suitably used.

As the epoxy resin and the photopolymerization initiator, an epoxy resin and a photopolymerization initiator similar to those described above can be used.

The addition amount of the photopolymerization initiator can be any addition amount to achieve a target sensitivity. The addition amount of the photopolymerization initiator is preferably in the range of from 0.5 to 5 mass% based on the epoxy resin. Also, a wavelength sensitizing agent may be added as needed, and examples of the wavelength sensitizing agent include "SP-100" (trade name) manufactured by ADEKA, and "UVS-1101", "UVS-1331", and "UVS-2171" (all trade names) manufactured by AIR WATER

PERFORMANCE CHEMICAL INC.

Further, additives may be added to the photosensitive resin as needed. For example, a flexibility-imparting agent may be added for the purpose to reduce the elastic modulus of the epoxy resin or a silane coupling agent may be added to obtain a further adhesion to the underlying layer.

Next, as shown in FIG. 2D, pattern exposure is performed via a mask (not shown) and heat treatment is further performed to form side walls 8. The mask is formed by forming a light shielding film such as a chromium film on a substrate made of a material such as glass or quartz that transmits light having an exposure wavelength in accordance with the pattern of the flow path 6. As the exposure device, a single-wavelength light source such as an i-line exposure stepper or a KrF stepper or a projection exposure device having a broad wavelength of a mercury lamp such as "mask aligner MPA-600Super" (trade name), manufactured by Canon Inc., can be used.

A second photosensitive resin layer 11 is formed on the substrate 1 on which the side walls 8 are formed in this manner, as shown in FIG. 2E. The second photosensitive resin layer 11 is a negative type photosensitive resin layer similar to the first photosensitive resin layer 10. As the photosensitive resin contained in the second photosensitive resin layer 11, a bisphenol type epoxy resin or a novolac type epoxy resin is preferably used. The second photosensitive resin layer 11 can be formed in the same manner as the first photosensitive resin layer 10.

Next, as shown in FIG. 2F, a coating film 12 of a solution of the photosensitive resin composition for forming the liquid-repellent and anti-fouling film 7 is formed on the second photosensitive resin layer 11. The coating film 12 can be formed by applying the resin composition by a spin coating method, a roll coating method, a slit coating method, or the like.

Next, as shown in FIG. 2G, pattern exposure is performed via a mask (not shown) and curing is performed to form the top plate 9 and the liquid-repellent and anti-fouling film 7. The mask is formed by forming a light shielding film such as a chromium film on a substrate made of a material such as glass or quartz that transmits light having an exposure wavelength in accordance with the pattern of the discharge port 5. As the exposure device, a single-wavelength light source such as an i-line exposure stepper or a KrF stepper or a projection exposure device having a broad wavelength of a mercury lamp such as "mask aligner MPA-600Super" (trade name), manufactured by Canon Inc., can be used.

Next, as shown in FIG. 2H, a non-exposed portion of the second photosensitive resin layer 11 and the coating film 12 are removed by development processing to form the discharge ports 5. By collectively exposing and developing the second photosensitive resin layer 11 and the coating film 12, the cationic polymerizable groups in the second photosensitive resin layer 11 and the coating film 12 react with each other, and the liquid-repellent and anti-fouling film 7 having high durability and high anti-static properties can be obtained. In this case, the non-exposed portion of the first photosensitive resin layer 10 is also simultaneously dissolved and removed to form the flow path 6.

Further, a heat treatment is performed as needed, and bonding members (not shown) for ink supply and electrical bonding (not shown) for driving the energy generating element 2 are performed, thereby completing the ink-jet recording head.

Recording Method

In a recording method according to an embodiment of the present disclosure, an image is recorded on a recording medium by using the ink-jet recording head and discharging a liquid, particularly an ink containing a pigment, from the ink-jet recording head.

In the ink-jet recording head, when the ink is filled, a side surface of the liquid-repellent and anti-fouling film always comes into contact with the ink. By using the ink-jet recording head, non-discharge can be suppressed because the liquid-repellent and anti-fouling film 7 has ink durability even when used for a long period of time.

Ink-Jet Recording Head Using Inorganic Substrate as Base Material

Step of Forming Bonding Substrate

For the ink-jet recording head, an inorganic substrate may be used as a base material. An example of an ink-jet recording head using an inorganic substrate is shown in FIG. 4A.

A liquid ejection head 25 includes a flow path substrate 14, an actuator substrate 15, and a nozzle substrate 16, and each substrate is joined via an adhesive 17. The actuator substrate 15 has a piezoelectric element 18 disposed on a surface thereof. As the piezoelectric element 18, for example, a lead zirconate titanate (PZT) film formed by a sol-gel method or a sputtering method can be applied. Such a piezoelectric element 18 is made of a sintered compact of a metal oxide crystal.

A flow path substrate 14 containing silicon is disposed to cover the piezoelectric element 18, and is bonded to the surface of the actuator substrate 15 via an adhesive 17. A nozzle substrate 16 is bonded to a back surface of the actuator substrate 15 via the adhesive 17. An ink tank (not shown) is disposed on the flow path substrate 14, and a liquid flow path portion 19 is formed so as to penetrate through the flow path substrate 14. The liquid flow path portion 19 communicates with an inside of the actuator substrate and is connected to a liquid discharge port 20 of the nozzle substrate.

When a drive voltage is applied to the piezoelectric element 18 from a drive IC (not shown), the piezoelectric element 18 is deformed by the inverse piezoelectric effect. By applying the drive voltage of the Pull-Push-Pull waveform, an interior of the cavity is expanded and contracted to cause a volume change, and when the liquid in the liquid flow path is pressurized, a meniscus is spread on the surface of the liquid discharge port 20. Thereafter, the liquid compressed by contraction is discharged as droplets from the liquid discharge port 20.

The ink-jet recording head has a water-repellent film 21 on a surface where the liquid discharge port 20 is provided. The water-repellent film 21 may be a liquid-repellent and anti-fouling film, and a silicone-containing film can be used. However, when the inside of the nozzle of the liquid discharge port 20 is water-repellent, the meniscus is spread at the back of the nozzle, and therefore, the discharge volume and the discharge direction may become unstable. Accordingly, the water-repellent film 21 is preferably formed by the following means. In FIGS. 4A and 4B, a peripheral region of the liquid discharge port 20 is defined as a region A. In FIGS. 5A to 5D, the region A will be described in an enlarged manner.

Method for Forming Water-Repellent Film

A method of producing a water-repellent film of a liquid ejection head will be described.

The formation of the water-repellent film is performed on a substrate bonded via an adhesive, and includes:

(1) a water-repellent film formation step of forming a water-repellent film on a surface of the nozzle substrate and inside the nozzle;
(2) a surface protection step of forming a protective member on the water-repellent film on the surface of the nozzle substrate;
(3) a plasma treatment step of making the water-repellent film inside the nozzle hydrophilic by a plasma treatment; and
(4) a protective member peeling step of peeling the protective member.

Each step will be described below.

(1) Water-Repellent Film Formation Step

A water-repellent film made of a silicone compound is formed on a nozzle substrate where a plurality of discharge ports are formed. FIG. 5A is an enlarged view of the discharge port 20 portion of the region A. It is preferable to use the nozzle substrate 16 in a state where the flow path substrate 14 and the actuator substrate 15 are bonded. The surface of the nozzle substrate may be cleaned before forming the water-repellent film. For example, plasma treatment, ion beam

cleaning, UV ozone cleaning, or the like can be used.

In a method of forming the water-repellent film 21, a film can be formed by a physical vapor phase method such as a vapor deposition method. In the vapor deposition method, a substrate is placed in a vacuum chamber and a water-repellent material is evaporated in the vacuum chamber. Further, the film can be formed by a liquid phase method using roller coating, dipping, or spin coating.

As shown in FIG. 5A, the water-repellent film 21 is formed on the surface where the discharge port 20 is formed. Here, since the discharge port 20 is formed on the nozzle substrate 16, the water-repellent film 22 is also formed inside the discharge port 20. Therefore, the water-repellent film 21 on the surface of the nozzle substrate is left, and the water-repellent film 22 on the side wall portion of the discharge port inside the nozzle is made hydrophilic.

(2) Protective Member Formation Step

Next, as shown in FIG. 5B, a protective member 23 is formed at a position where the water-repellent film 21 is to be left.

The protective member 23 is not particularly limited, and may be made of a resin material, a tape, or the like. When the protective member around the discharge port floats, the water-repellent film on the surface is rendered hydrophilic by the subsequent plasma treatment. In this case, the discharge port is defective because the meniscus becomes unstable. Therefore, it is also possible to apply a protective tape under reduced pressure to prevent the protective tape from floating.

(3) Plasma Treatment Step

Next, as shown in FIG. 5C, the plasma treatment is performed from the flow path substrate side to make the water-repellent film 22 on the side wall portion of the discharge port hydrophilic to form a hydrophilic water-repellent film 24.

As an example of the plasma treatment method, a nozzle substrate is set in a vacuum pressure chamber to generate oxygen plasma. The plasma reaches the discharge port from the flow path forming substrate via the nozzle substrate 16 as shown in FIG. 5C. For the plasma, devices such as microwave and remote plasma can be used depending on the purpose. It is preferable to adopt conditions in which a bent flow path is used to eliminate the substrate bias, thereby avoiding reliance on ion assist. Accordingly, it becomes possible to move radicals isotropically based on the reaction of the radicals. Regarding the treatment temperature, an upper limit temperature may be determined in terms of the heat resistance of the protective tape to be used, considering the throughput, because the lower limit temperature relates to the processing speed.

(4) Protective Film Peeling Step

Finally, as shown in FIG. 5D, the liquid ejection head is produced by peeling the protective member 23 from the nozzle substrate. Since the liquid ejection head thus obtained has the inside of the nozzle hydrophilic, a discharge volume and the discharge direction are stabilized.

Examples

The present disclosure will be further described below with reference to the examples, but the present disclosure is not limited thereto.

Example 1

Preparation of Liquid-Repellent and Anti-Fouling Film on Base Material

A liquid-repellent and anti-fouling film was formed according to the procedures shown in FIGS. 3A and 3B. A photosensitive resin composition having the formulation of Example 1 shown in Table 4-1 was applied onto a silicon substrate 13 to form a coating film 12, which was then heat-treated at 70°C for 3 minutes. The coating film 12 was then exposed to light at 5000 $Jm^{-2}$ using an i-line exposure stepper ("FPA-3000i5+" manufactured by Canon Inc.), and heat-treated at 90°C for 5 minutes. After washing using PGMEA, a heat treatment was further performed at 200°C for 1 hour to form a liquid-repellent and anti-fouling film 7. A thickness of the liquid-repellent and anti-fouling film, which is the silicone-containing film, was set to 0.5 μm.

Note that in Tables 4-1, 4-2 and Tables 5-1, 5-2, the following were used as the initiators and a solvent.

Photopolymerization initiators: CPI-410S, CPI-410B, and CPI-310FG (all are manufactured by San-Apro Ltd.)
Solvent: PGMEA

Production of Ink-Jet Recording Head

In addition, an ink-jet recording head was manufactured by steps shown in FIGS. 2A to 2H separately from the liquid-repellent and anti-fouling film.

First, as shown in FIG. 2A, a substrate 1 having a surface where the energy generating element 2 was provided was prepared, and an ink feeding port 3 penetrating the substrate 1 was formed by etching using TMAH as shown in FIG. 2B.

Next, as shown in FIG. 2C, the cationic polymerizable resin composition shown in Table 1 was transferred onto the substrate 1 including the energy generating element 2 by a laminate method to form a first photosensitive resin layer 10. Further, as shown in FIG. 2D, pattern exposure was performed through a mask made of quartz (not shown) and heat treatment was performed at 90°C for 5 minutes to form sidewalls 8. As the exposure device, an i-line exposure stepper ("FPA-3000i5+" manufactured by Canon Inc.) was used, and the exposure amount was 10,000 $Jm^{-2}$.

A second photosensitive resin layer 11 was formed on the substrate 1 in which the side walls 8 were formed in this manner, as shown in FIG. 2E. The second photosensitive resin layer 11 was transferred by a laminate method using the cationic polymerizable resin composition shown in Table 2.

Then, as shown in FIG. 2F, the photosensitive resin composition of the formulation of Example 1 shown in Table 4-1 was applied onto the second photosensitive resin layer 11 and heat treated at 70°C for 3 minutes. Further, the second photosensitive resin layer 11 and the coating film 12 were subjected to pattern exposure at a time via a mask (not shown) having a pattern of the discharge ports 5, and heat treated at 90°C for 5 minutes. As the exposure device, an i-line exposure stepper ("FPA-3000i5+" manufactured by Canon Inc.) was used, and the exposure amount was 5000 $Jm^{-2}$ (FIG. 2G).

Finally, the non-exposed portions of the photosensitive resin layer and the coating film were dissolved and removed using PGMEA, and heat treated at 200°C for 1 hour to form the discharge ports 5, the flow path 6, and the liquid-repellent and anti-fouling film 7 (FIG. 2H).

Note that a thickness of the liquid-repellent and anti-fouling film, which is the silicone-containing film, was set to 0.5 μm.

[Table 1]

| Table 1 | | |
|---|---|---|
| Epoxy resin | Trade name: EPICLOM N-695, manufactured by DIC | 100 parts by mass |
| Photopolymerization initiator | Trade name: ADEKA ARKLS SP-172 manufactured by ADEKA | 6 parts by mass |
| Solvent | Trade name: OMR series, manufactured by TOKYO OHKA KOGYO CO., LTD. | 70 parts by mass |

[Table 2]

| Table 2 | | |
|---|---|---|
| Epoxy resin | Trade name: 157S70, manufactured by Mitsubishi Chemical Corporation | 100 parts by mass |
| Photopolymerization initiator | Trade name: CPI-410S manufactured by San-Apro Ltd. | 0.01 parts by mass |
| Solvent | Trade name: PGMEA, manufactured by Kishida Chemical Co., Ltd. | 20 parts by mass |

Examples 2 to 43

A liquid-repellent and anti-fouling film on a base material and an ink-jet recording head were produced in the same manner as in Example 1 except that the resin compositions of the formulations of Examples 2 to 43 shown in Tables 4-1 and 4-2, respectively, were used in the formation of the liquid-repellent and anti-fouling film 7.

Comparative Examples 1 to 42

A liquid-repellent and anti-fouling film on a base material and an ink-jet recording head were produced in the

same manner as in Example 1 except that the resin compositions of the formulations of Comparative Examples 1 to 42 shown in Tables 5-1 and 5-2, respectively, were used in the formation of the liquid-repellent and anti-fouling film 7.

Note that the silicone compounds, epoxy resins, and initiators used for the compositions of the Examples and Comparative Examples in Tables 4-1, 4-2 and Tables 5-1, 5-2 are as follows.

Examples using the silicone compound having a structure shown in Formula (1) are Examples 1 to 43 and Comparative Examples 1 to 42.

The epoxy-containing group of the silicone compound has a glycidyl ether group or epoxycyclohexyl group, in Examples 1, 4, 5, 7, 8, 10, 11, 12, 15, 18, 19, 21, 22, 24, 25, 26, 27, 30, 31, 32, 35, 36, 39, 40, and 43, and Comparative Examples 1, 3, 4, 5, 6, 7, 8, 9, 10, 11, 12, 13, 14, 15, 16, 17, 18, 19, 20, 21, 24, 25, 26, 27, 28, 29, 30, 31, 32, 33, 34, 35, 36, 37, 38, 39, 40, 41, and 42.

The epoxy-containing group of the silicone compound is a 2-(3,4-epoxycyclohexyl)ethyl group in Examples 2, 3, 6, 9, 13, 14, 16, 17, 20, 23, 28, 29, 33, 34, 37, 38, 41, and 42, and Comparative Examples 2, 22, and 23.

The photopolymerization initiator is cationic polymerizable in Examples 1 to 43 and Comparative Examples 1 to 42.

Evaluation of Liquid-Repellent and Anti-Fouling Film

The following evaluations were made on the liquid-repellent and anti-fouling films prepared in Examples 1 to 43 and Comparative Examples 1 to 42.

Initial Water Repellency and Wipe Durability

A dynamic receding contact angle $\theta\gamma$ of the liquid-repellent and anti-fouling film to pure water was measured using a micro contact angle meter (DropMeasure (trade name), manufactured by MICROJET) to evaluate initial water repellency. A value of the initial water repellency was defined as a contact angle at the outermost surface of the silicone-containing film.

The liquid-repellent and anti-fouling films were also wiped with a pigment ink under the conditions shown in Table 3. Thereafter, $\theta\gamma$ was measured as described above and the mechanical strength was evaluated. Values of wipe durability values were evaluated when initial water repellency was 1.00.

[Table 3]

| Table 3 | | |
|---|---|---|
| Wipe member | Element | HNBR |
| | Thickness | 0.65mm |
| Wipe condition | Degree of freedom | 3.0mm |
| | Depression depth | 0.5mm |
| | Wiping speed | 100mm/sec |
| | Number of wipes | 2000 cycles |

Evaluation of Ink-Jet Recording Head

The ink-jet recording heads produced in Examples 1 to 43 and Comparative Examples 1 to 42 were evaluated as follows.

A continuous printing test was performed using a printer MB5330 manufactured by Canon under an environment of 30°C, 80% RH, and the presence or absence of dot deflection was visually confirmed. Continuous printing tests were performed on 100 sheets of A4-sized solid prints continuously. Printing quality was determined as NG when the deflection occurred even at one place in the A4-sized printing plate.

Elemental Analysis in Depth Direction

The silicone-containing film, which is the liquid-repellent and anti-fouling film obtained in Examples 1 to 43 and Comparative Examples 1 to 42 was subjected to elemental analysis by ToF-SIMS with etching under the following etching conditions and analysis conditions. Then, a value of the ratio of the abundance of $SiC_3H_9^+$ was obtained. Tables 4-1, 4-2 and Tables 5-1, 5-2 show the results.

Etching conditions and analysis conditions are as follows.

- · Measuring apparatus: nanoTOF II (Trade name, manufactured by ULVAC-PHI, Inc)
- · Primary ion species: $Au_1^+$
- · Acceleration voltage: 30 kV
- · Primary ion current: 3.5 μA
- · Repeat frequency: 8.2 kHz
- · Raster mode: Bunched
- · Raster size: 100 μm × 100 μm
- · Measurement mode: Positive
- · Neutralizing electron gun: Use
- · Measurement time: 120 seconds
- · Sample preparation: Using the liquid-repellent and anti-fouling film on a base material produced
- · Sample pretreatment: None

Using standard software (WincandenceN) manufactured by ULVAC-PHI, INC, the evaluation was performed based on the mass numbers of Si ions and fragment ions resulting from the resin or silane compound. The ion intensity resulting from the silicon fragment ion (m/z73) with mass number 73 was confirmed, and this was taken as the abundance of $SiC_3H_9^+$ present on the outermost surface (0s) of the silicone-containing film.
Further, after the silicone-containing film is sputtered under the following conditions, elemental analysis by ToF-SIMS is performed under the same conditions as described above to confirm the ion intensity derived from silicon fragment ions (m/z 73) having a mass number of 73, which was used as the abundance of $SiC_3H_9^+$ at an etching time of 30 s.
The sputtering conditions are as follows.

Sputtering species: $C_{60}^+$
Acceleration voltage: 40 kV
Current: 6.5 nA
Raster size: 800 × 800 μm
Irradiation time: 30 sec/cycle
Sputtering time: 600 sec

In addition, when a $SiO_2$ film was sputtered under the same condition in advance and the cutting depth was confirmed, it was confirmed that cutting was performed at 5 nm for 60 s.
FIG. 6 is a graph showing a change of abundance of $SiC_3H_9^+$ to an abundance of the $SiC_3H_9^+$ at an outermost surface (0 s) of the silicone-containing film depending on the etching time, when a composition analysis by a time of flight secondary ion mass spectrometry ToF-SIMS is performed while performing etching in a thickness direction perpendicular to a surface of a silicone-containing film under the above etching conditions.
The ions derived from the silicone-containing film are $SiC_3H_9^+$, and the ions derived from the underlying organic resin film are $C_7H_7$. $SiC_3H_9^+$ was reduced by about 0.9 at etching time of 30 s, assuming that the abundance in the surface was 1, and it was confirmed that the silicone compound was present uniformly inside the film.

[Table 4-1]

Table 4-1

| Example No. | Silicone | | | Epoxy resin | | | Initiator | | | Solvent (parts) | Initial water repellency | Wipe test (Initial 1) | Ratio of abundance of $SiC_3H_9^+$ |
|---|---|---|---|---|---|---|---|---|---|---|---|---|---|
| | Kind | Product name | Parts | Product name | Epoxy equivalent | Parts | Kind | Product name | Parts | | (°) | | |
| 1 | Both ends | X-22-163B | 0.8 | EHPE 3150 | 170-190 | 100 | Phosphorus | CPI-410S | 1.5 | 920 | 94 | 0.93 | 0.91 |
| 2 | Both ends alicyclic type | X-22-169B | 0.8 | EHPE 3150 | 170-190 | 100 | Phosphorus | CPI-410S | 1.5 | 920 | 95 | 0.96 | 0.95 |
| 3 | Both ends alicyclic type | X-22-169AS | 0.8 | EHPE 3150 | 170-190 | 100 | Phosphorus | CPI-410S | 1.5 | 920 | 90 | 0.94 | 0.95 |
| 4 | Side chain | X-22-343 | 0.8 | EHPE 3150 | 170-190 | 100 | Phosphorus | CPI-410S | 1.5 | 920 | 88 | 0.80 | 0.80 |
| 5 | Both ends and side chain | X-22-9002 | 0.8 | EHPE 3150 | 170-190 | 100 | Phosphorus | CPI-410S | 1.5 | 920 | 88 | 0.91 | 0.92 |
| 6 | Side chain alicyclic type | DOWSIL BY 16-839-Fluid | 0.8 | EHPE 3150 | 170-190 | 100 | Phosphorus | CPI-410S | 1.5 | 920 | 86 | 0.88 | 0.87 |
| 7 | Side chain | DOWSIL BY 16-876 | 0.8 | EHPE 3150 | 170-190 | 100 | Phosphorus | CPI-410S | 1.5 | 920 | 83 | 0.83 | 0.80 |
| 8 | Side chain | DOWSIL FZ-3736 Fluid | 0.8 | EHPE 3150 | 170-190 | 100 | Phosphorus | CPI-410S | 1.5 | 920 | 86 | 0.80 | 0.80 |

(continued)

| Table 4-1 | | | | | | | | | | | | | |
|---|---|---|---|---|---|---|---|---|---|---|---|---|---|
| Example No. | Silicone | | | Epoxy resin | | | Initiator | | | Solvent (parts) | Initial water repellency | Wipe test (Initial 1) | Ratio of abundance of $SiC_3H_9^+$ |
| | Kind | Product name | Parts | Product name | Epoxy equivalent | Parts | Kind | Product name | Parts | | (°) | | |
| 9 | Side chain alicyclic type | DOWSIL L-9300 | 0.8 | EHPE 3150 | 170-190 | 100 | Phosphorus | CPI-410S | 1.5 | 920 | 83 | 0.82 | 0.89 |
| 10 | Side chain | DOWSIL SF 8411 Fluid | 0.8 | EHPE 3150 | 170-190 | 100 | Phosphorus | CPI-410S | 1.5 | 920 | 87 | 0.85 | 0.82 |
| 11 | Side chain | DOWSIL SF 8413 Fluid | 0.8 | EHPE 3150 | 170-190 | 100 | Phosphorus | CPI-410S | 1.5 | 920 | 85 | 0.81 | 0.81 |
| 12 | Side chain | DOWSIL SF 8421 Fluid | 0.8 | EHPE 3150 | 170-190 | 100 | Phosphorus | CPI-410S | 1.5 | 920 | 85 | 0.84 | 0.80 |
| 13 | Both ends alicyclic type | X-22-169B | 1.0 | EHPE 3150 | 170-190 | 100 | Borate | CPI-410B | 3.00 | 920 | 95 | 0.92 | 0.89 |
| 14 | Both ends alicyclic type | X-22-169B | 1.0 | EHPE 3150 | 170-190 | 100 | Gallate | CPI-310FG | 3.00 | 920 | 93 | 0.91 | 0.87 |
| 15 | Both ends | X-22-163B | 0.8 | 157S70 | 200-220 | 100 | Phosphorus | CPI-410S | 1.5 | 920 | 92 | 0.89 | 0.91 |
| 16 | Both ends alicyclic type | X-22-169B | 0.8 | 157S70 | 200-220 | 100 | Phosphorus | CPI-410S | 1.5 | 920 | 93 | 0.91 | 0.90 |
| 17 | Both ends alicyclic type | X-22-169AS | 0.8 | 157S70 | 200-220 | 100 | Phosphorus | CPI-410S | 1.5 | 920 | 89 | 0.90 | 0.91 |

(continued)

| Table 4-1 | | | | | | | | | | | | | |
|---|---|---|---|---|---|---|---|---|---|---|---|---|---|
| Example No. | Silicone | | | Epoxy resin | | | Initiator | | | Solvent (parts) | Initial water repellency | Wipe test (Initial 1) | Ratio of abundance of $SiC_3H_9^+$ |
| | Kind | Product name | Parts | Product name | Epoxy equivalent | Parts | Kind | Product name | Parts | | (°) | | |
| 18 | Side chain | X-22-343 | 0.8 | 157S70 | 200-220 | 100 | Phosphorus | CPI-410S | 1.5 | 920 | 88 | 0.80 | 0.80 |
| 19 | Both ends and side chain | X-22-9002 | 0.8 | 157S70 | 200-220 | 100 | Phosphorus | CPI-410S | 1.5 | 920 | 87 | 0.92 | 0.91 |
| 20 | Side chain alicyclic type | DOWSIL BY 16-839-Fluid | 0.8 | 157S70 | 200-220 | 100 | Phosphorus | CPI-410S | 1.5 | 920 | 88 | 0.85 | 0.81 |
| 21 | Side chain | DOWSIL BY 16-876 | 0.8 | 157S70 | 200-220 | 100 | Phosphorus | CPI-410S | 1.5 | 920 | 83 | 0.84 | 0.80 |

[Table 4-2]

Table 4-2

| Example No. | Silicone | | | Epoxy resin | | | Initiator | | | Solvent (parts) | Initial water repellency | Wipe test (Initial 1) | Ratio of abundance of $SiC_3H_9^+$ |
|---|---|---|---|---|---|---|---|---|---|---|---|---|---|
| | Kind | Product name | Parts | Product name | Epoxy equivalent | Parts | Kind | Product name | Parts | | (°) | | |
| 22 | Side chain | DOWSIL FZ-3736 Fluid | 0.8 | 157S70 | 200-220 | 100 | Phosphorus | CPI-410S | 1.5 | 920 | 82 | 0.84 | 0.81 |
| 23 | Side chain alicyclic type | DOWSIL L-9300 | 0.8 | 157S70 | 200-220 | 100 | Phosphorus | CPI-410S | 1.5 | 920 | 83 | 0.88 | 0.88 |
| 24 | Side chain | DOWSIL SF 8411 Fluid | 0.8 | 157S70 | 200-220 | 100 | Phosphorus | CPI-410S | 1.5 | 920 | 84 | 0.84 | 0.81 |
| 25 | Side chain | DOWSIL SF 8413 Fluid | 0.8 | 157S70 | 200-220 | 100 | Phosphorus | CPI-410S | 1.5 | 920 | 83 | 0.85 | 0.80 |
| 26 | Side chain | DOWSIL SF 8421 Fluid | 0.8 | 157S70 | 200-220 | 100 | Phosphorus | CPI-410S | 1.5 | 920 | 83 | 0.85 | 0.80 |
| 27 | Both ends | X-22-163B | 0.8 | jER-1031S | 180-220 | 100 | Phosphorus | CPI-410S | 1.5 | 920 | 91 | 0.88 | 0.90 |
| 28 | Both ends alicyclic type | X-22-169B | 0.8 | jER-1031S | 180-220 | 100 | Phosphorus | CPI-410S | 1.5 | 920 | 89 | 0.87 | 0.91 |
| 29 | Both ends alicyclic type | X-22-169AS | 0.8 | jER-1031S | 180-220 | 100 | Phosphorus | CPI-410S | 1.5 | 920 | 88 | 0.93 | 0.91 |
| 30 | Side chain | X-22-343 | 0.8 | jER-1031S | 180-220 | 100 | Phosphorus | CPI-410S | 1.5 | 920 | 88 | 0.80 | 0.82 |

(continued)

Table 4-2

| Example No. | Silicone | | | Epoxy resin | | | Initiator | | | Solvent (parts) | Initial water repellency | Wipe test (Initial 1) | Ratio of abundance of $SiC_3H_9^+$ |
|---|---|---|---|---|---|---|---|---|---|---|---|---|---|
| | Kind | Product name | Parts | Product name | Epoxy equivalent | Parts | Kind | Product name | Parts | | (°) | | |
| 31 | Both ends and side chain | X-22-9002 | 0.8 | jER-1031S | 180-220 | 100 | Phosphorus | CPI-410S | 1.5 | 920 | 89 | 0.93 | 0.91 |
| 32 | Both ends | X-22-163B | 0.8 | EPICLON N-695 | 209-219 | 100 | Phosphorus | CPI-410S | 1.5 | 920 | 84 | 0.85 | 0.88 |
| 33 | Both ends alicyclic type | X-22-169B | 0.8 | EPICLON N-695 | 209-219 | 100 | Phosphorus | CPI-410S | 1.5 | 920 | 88 | 0.86 | 0.85 |
| 34 | Both ends alicyclic type | X-22-169AS | 0.8 | EPICLON N-695 | 209-219 | 100 | Phosphorus | CPI-410S | 1.5 | 920 | 86 | 0.85 | 0.82 |
| 35 | Both ends and side chain | X-22-9002 | 0.8 | EPICLON N-695 | 209-219 | 100 | Phosphorus | CPI-410S | 1.5 | 920 | 87 | 0.88 | 0.83 |
| 36 | Both ends | X-22-163B | 0.8 | EPICLON N-865 | 209-219 | 100 | Phosphorus | CPI-410S | 1.5 | 920 | 89 | 0.89 | 0.88 |
| 37 | Both ends alicyclic type | X-22-169B | 0.8 | EPICLON N-865 | 209-219 | 100 | Phosphorus | CPI-410S | 1.5 | 920 | 88 | 0.85 | 0.89 |
| 38 | Both ends alicyclic type | X-22-169AS | 0.8 | EPICLON N-865 | 209-219 | 100 | Phosphorus | CPI-410S | 1.5 | 920 | 85 | 0.87 | 0.87 |

(continued)

| Table 4-2 | | | | | | | | | | | | | |
|---|---|---|---|---|---|---|---|---|---|---|---|---|---|
| Example No. | Silicone | | | Epoxy resin | | | Initiator | | | Solvent (parts) | Initial water repellency | Wipe test (Initial 1) | Ratio of abundance of $SiC_3H_9^+$ |
| | Kind | Product name | Parts | Product name | Epoxy equivalent | Parts | Kind | Product name | Parts | | (°) | | |
| 39 | Both ends and side chain | X-22-9002 | 0.8 | EPICLON N-865 | 209-219 | 100 | Phosphorus | CPI-410S | 1.5 | 920 | 84 | 0.88 | 0.88 |
| 40 | Both ends | X-22-163B | 0.8 | CELLOXIDE 2021 | 130 | 100 | Phosphorus | CPI-410S | 1.5 | 920 | 87 | 0.88 | 0.87 |
| 41 | Both ends alicyclic type | X-22-169B | 0.8 | CELLOXIDE 2021 | 130 | 100 | Phosphorus | CPI-410S | 1.5 | 920 | 88 | 0.87 | 0.88 |
| 42 | Both ends alicyclic type | X-22-169AS | 0.8 | CELLOXIDE 2021 | 130 | 100 | Phosphorus | CPI-410S | 1.5 | 920 | 86 | 0.88 | 0.86 |
| 43 | Both ends and side chain | X-22-9002 | 0.8 | CELLOXIDE 2021 | 130 | 100 | Phosphorus | CPI-410S | 1.5 | 920 | 84 | 0.86 | 0.87 |

[Table 5-1]

Table 5-1

| C.E. No. | Silicone | | | Resin | | | | Initiator | | | Solvent (parts) | Initial water repellency | Wipe test (Initial 1) | Ratio of abundance of $SiC_3H_9^+$ |
|---|---|---|---|---|---|---|---|---|---|---|---|---|---|---|
| | Kind | Product name | Parts | Product name | Kind | Epoxy equivalent | Parts | Kind | Product name | Part | | (°) | | |
| 1 | Both ends | X-22-163B | 0.8 | ACRYDIC A-418 | Acrylic resin | - | 100 | Phosphorus | CPI-410S | 1.5 | 920 | 56 | 0.31 | 0.41 |
| 2 | Both ends alicyclic type | X-22-169B | 0.8 | BURNOCK PH 2891 | Acrylic resin | - | 100 | Phosphorus | CPI-410S | 1.5 | 920 | 45 | 0.43 | 0.38 |
| 3 | One end | X-22-173BX | 0.8 | EHPE 3150 | Epoxy resin | 170-190 | 100 | Phosphorus | CPI-410S | 1.5 | 920 | 87 | 0.28 | 0.37 |
| 4 | One end | X-22-173DX | 0.8 | EHPE 3150 | Epoxy resin | 170-190 | 100 | Phosphorus | CPI-410S | 1.5 | 920 | 92 | 0.36 | 0.36 |
| 5 | One end | X-22-173BX | 0.8 | 157S70 | Epoxy resin | 200-220 | 100 | Phosphorus | CPI-410S | 1.5 | 920 | 98 | 0.24 | 0.20 |
| 6 | One end | X-22-173DX | 0.8 | 157S70 | Epoxy resin | 200-220 | 100 | Phosphorus | CPI-410S | 1.5 | 920 | 95 | 0.28 | 0.22 |
| 7 | One end | X-22-173BX | 0.8 | jER-1031S | Epoxy resin | 180-220 | 100 | Phosphorus | CPI-410S | 1.5 | 920 | 90 | 0.31 | 0.31 |
| 8 | One end | X-22-173DX | 0.8 | jER-1031S | Epoxy resin | 180-220 | 100 | Phosphorus | CPI-410S | 1.5 | 920 | 89 | 0.43 | 0.35 |
| 9 | Side chain | X-22-343 | 0.8 | jER-1004 | Epoxy resin | 770-850 | 100 | Phosphorus | CPI-410S | 1.5 | 920 | 80 | 0.26 | 0.44 |
| 10 | One end | X-22-173BX | 0.8 | jER-1004 | Epoxy resin | 770-850 | 100 | Phosphorus | CPI-410S | 1.5 | 920 | 92 | 0.24 | 0.35 |
| 11 | One end | X-22-173DX | 0.8 | jER-1004 | Epoxy resin | 770-850 | 100 | Phosphorus | CPI-410S | 1.5 | 920 | 90 | 0.35 | 0.41 |
| 12 | Side chain | X-22-343 | 0.8 | jER-1007 | Epoxy resin | 1200-1400 | 100 | Phosphorus | CPI-410S | 1.5 | 920 | 79 | 0.36 | 0.37 |

(continued)

Table 5-1

| C.E. No. | Silicone | | | Resin | | | | Initiator | | | Solvent (parts) | Initial water repellency | Wipe test (Initial 1) | Ratio of abundance of $SiC_3H_9^+$ |
|---|---|---|---|---|---|---|---|---|---|---|---|---|---|---|
| | Kind | Product name | Parts | Product name | Kind | Epoxy equivalent | Parts | Kind | Product name | Part | | (°) | | |
| 13 | One end | X-22-173BX | 0.8 | jER-1007 | Epoxy resin | 1200-1400 | 100 | Phosphorus | CPI-410S | 1.5 | 920 | 78 | 0.31 | 0.41 |
| 14 | One end | X-22-173DX | 0.8 | jER-1007 | Epoxy resin | 1200-1400 | 100 | Phosphorus | CPI-410S | 1.5 | 920 | 80 | 0.27 | 0.38 |
| 15 | Side chain | X-22-343 | 0.8 | jER-1009 | Epoxy resin | 1750-2250 | 100 | Phosphorus | CPI-410S | 1.5 | 920 | 75 | 0.37 | 0.31 |
| 16 | One end | X-22-173BX | 0.8 | jER-1009 | Epoxy resin | 1750-2250 | 100 | Phosphorus | CPI-410S | 1.5 | 920 | 76 | 0.25 | 0.29 |
| 17 | One end | X-22-173DX | 0.8 | jER-1009 | Epoxy resin | 1750-2250 | 100 | Phosphorus | CPI-410S | 1.5 | 920 | 74 | 0.34 | 0.39 |
| 18 | Side chain | X-22-343 | 0.8 | jER-1010 | Epoxy resin | 3000-5000 | 100 | Phosphorus | CPI-410S | 1.5 | 920 | 68 | 0.35 | 0.29 |
| 19 | One end | X-22-173BX | 0.8 | jER-1010 | Epoxy resin | 3000-5000 | 100 | Phosphorus | CPI-410S | 1.5 | 920 | 66 | 0.21 | 0.42 |
| 20 | One end | X-22-173DX | 0.8 | jER-1010 | Epoxy resin | 3000-5000 | 100 | Phosphorus | CPI-410S | 1.5 | 920 | 70 | 0.29 | 0.37 |
| 21 | Both ends | X-22-163B | 0.8 | jER-1256 | Epoxy resin | 7500-8500 | 100 | Phosphorus | CPI-410S | 1.5 | 920 | 69 | 0.39 | 0.62 |

[Table 5-2]

Table 5-2

| C.E. No. | Silicone | | | Resin | | | | Initiator | | | Solvent (parts) | Initial water repellency | Wipe test (Initial 1) | Ratio of abundance of $SiC_3H_9^+$ |
|---|---|---|---|---|---|---|---|---|---|---|---|---|---|---|
| | Kind | Product name | Parts | Product name | Kind | Epoxy equivalent | Parts | Kind | Product name | Parts | | (°) | | |
| 22 | Both ends alicyclic type | X-22-169B | 0.8 | jER-1256 | Epoxy resin | 7500-8500 | 100 | Phosphorus | CPI-410S | 1.5 | 920 | 65 | 0.58 | 0.61 |
| 23 | Both ends alicyclic type | X-22-169AS | 0.8 | jER-1256 | Epoxy resin | 7500-8500 | 100 | Phosphorus | CPI-410S | 1.5 | 920 | 71 | 0.59 | 0.58 |
| 24 | Side chain | X-22-343 | 0.8 | jER-1256 | Epoxy resin | 7500-8500 | 100 | Phosphorus | CPI-410S | 1.5 | 920 | 65 | 0.54 | 0.21 |
| 25 | Both ends and side chain | X-22-9002 | 0.8 | jER-1256 | Epoxy resin | 7500-8500 | 100 | Phosphorus | CPI-410S | 1.5 | 920 | 65 | 0.64 | 0.33 |
| 26 | One end | X-22-173BX | 0.8 | jER-1256 | Epoxy resin | 7500-8500 | 100 | Phosphorus | CPI-410S | 1.5 | 920 | 70 | 0.57 | 0.29 |
| 27 | One end | X-22-173DX | 0.8 | jER-1256 | Epoxy resin | 7500-8500 | 100 | Phosphorus | CPI-410S | 1.5 | 920 | 71 | 0.64 | 0.18 |
| 28 | Side chain | X-22-343 | 0.8 | EPICLON N-695 | Epoxy resin | 209-219 | 100 | Phosphorus | CPI-410S | 1.5 | 920 | 85 | 0.28 | 0.25 |
| 29 | One end | X-22-173BX | 0.8 | EPICLON N-695 | Epoxy resin | 209-219 | 100 | Phosphorus | CPI-410S | 1.5 | 920 | 86 | 0.39 | 0.49 |
| 30 | One end | X-22-173DX | 0.8 | EPICLON N-695 | Epoxy resin | 209-219 | 100 | Phosphorus | CPI-410S | 1.5 | 920 | 83 | 0.46 | 0.45 |
| 31 | Side chain | X-22-343 | 0.8 | EPICLON N-865 | Epoxy resin | 209-219 | 100 | Phosphorus | CPI-410S | 1.5 | 920 | 82 | 0.43 | 0.21 |

(continued)

Table 5-2

| C.E. No. | Silicone | | | Resin | | | | Initiator | | | Solvent (parts) | Initial water repellency | Wipe test (Initial 1) | Ratio of abundance of $SiC_3H_9^+$ |
|---|---|---|---|---|---|---|---|---|---|---|---|---|---|---|
| | Kind | Product name | Parts | Product name | Kind | Epoxy equivalent | Parts | Kind | Product name | Parts | | (°) | | |
| 32 | One end | X-22-173BX | 0.8 | EPICLON N-865 | Epoxy resin | 209-219 | 100 | Phosphorus | CPI-410S | 1.5 | 920 | 85 | 0.64 | 0.29 |
| 33 | One end | X-22-173DX | 0.8 | EPICLON N-865 | Epoxy resin | 209-219 | 100 | Phosphorus | CPI-410S | 1.5 | 920 | 82 | 0.16 | 0.28 |
| 34 | Side chain | X-22-343 | 0.8 | EPICLON 4050 | Epoxy resin | 900-1000 | 100 | Phosphorus | CPI-410S | 1.5 | 920 | 76 | 0.38 | 0.28 |
| 35 | One end | X-22-173BX | 0.8 | EPICLON 4050 | Epoxy resin | 900-1000 | 100 | Phosphorus | CPI-410S | 1.5 | 920 | 75 | 0.46 | 0.41 |
| 36 | One end | X-22-173DX | 0.8 | EPICLON 4050 | Epoxy resin | 900-1000 | 100 | Phosphorus | CPI-410S | 1.5 | 920 | 70 | 0.64 | 0.36 |
| 37 | Side chain | X-22-343 | 0.8 | EPICLON 7050 | Epoxy resin | 1750-2100 | 100 | Phosphorus | CPI-410S | 1.5 | 920 | 76 | 0.47 | 0.27 |
| 38 | One end | X-22-173BX | 0.8 | EPICLON 7050 | Epoxy resin | 1750-2100 | 100 | Phosphorus | CPI-410S | 1.5 | 920 | 75 | 0.64 | 0.40 |
| 39 | One end | X-22-173DX | 0.8 | EPICLON 7050 | Epoxy resin | 1750-2100 | 100 | Phosphorus | CPI-410S | 1.5 | 920 | 75 | 0.38 | 0.35 |
| 40 | Side chain | X-22-343 | 0.8 | CELLOXIDE 2021 | Epoxy resin | 130 | 100 | Phosphorus | CPI-410S | 1.5 | 920 | 71 | 0.17 | 0.20 |
| 41 | One end | X-22-173BX | 0.8 | CELLOXIDE 2021 | Epoxy resin | 130 | 100 | Phosphorus | CPI-410S | 1.5 | 920 | 86 | 0.37 | 0.28 |
| 42 | One end | X-22-173DX | 0.8 | CELLOXIDE 2021 | Epoxy resin | 130 | 100 | Phosphorus | CPI-410S | 1.5 | 920 | 81 | 0.35 | 0.27 |

In the table, "C.E." indicates "Comparative Example", and parts represent parts by mass. The units of epoxy equivalent are g/eq. The type of the initiator indicates the type of the anion. The initial water-repellent value indicates the contact angle (°) at the outermost surface of the silicone-containing film. The numerical value of the wipe test is the value of the water-repellent value after the wipe test, when the initial water-repellent value is 1.00 with respect to the dynamic receding contact angle $\theta\gamma$.

The silicone compound with the product name X-22 is manufactured by Shin-Etsu Chemical Co., Ltd. The DOWSIL series is manufactured by Dow Toray Co., Ltd. EHPE 3150, the CELLOXIDE series is manufactured by Daicel Corporation. The 157S70, jER series is manufactured by Mitsubishi Chemical Corporation. The EPICLON series is produced by Dainippon Ink and Chemicals, Inc.. ACRYDIC A-418 and BURNOCK PH 2891 are manufactured by DIC Corporation.

Epoxy silicone is as follows.

"Both end alicyclic type" represents a silicone compound having alicyclic epoxy-containing groups at both ends of a silicone main chain, and the silicone compound has no epoxy-containing group in a side chain.

Regarding the "Both ends", a silicone compound has epoxy-containing groups (not alicyclic epoxy) at both ends of the silicone main chain, and the silicone compounds have no epoxy-containing groups in the side chain.

Regarding the "Side chain", a silicone compound has an epoxy-containing group (not an alicyclic epoxy) in the side chain of the silicone main chain, and the silicone compound has no epoxy-containing group at the end.

The "Side chain alicyclic type" represents a silicone compound having an alicyclic epoxy-containing group in the side chain of the silicone main chain, and the silicone compound has no epoxy-containing group at the end.

Regarding the "Both ends and side chain", a silicone compound has epoxy-containing groups at both ends and side chains of the silicone main chain.

Regarding the "One end", a silicone compound has an epoxy-containing group at one end of the silicone main chain.

As shown in Tables 4-1 and 4-2, in Examples 1 to 43, films with silicone evenly distributed in the depth direction can be achieved, resulting in superior wipe durability. In particular, silicone compounds having epoxy-containing groups at both ends of the silicone can produce films in which the silicone is distributed more uniformly in the depth direction, and show better wipe durability.

It is considered that a highly reactive 3-glycidoxypropyl group and 2-(3,4-epoxycyclohexyl)alkyl group are contained at the ends, resulting in a sufficient cure of the siloxane main chain in the film.

It was found that the epoxy resin with a smaller epoxy equivalent is superior in reactivity with a silicone compound, and therefore has superior wipe durability. In particular, when the epoxy equivalent was 300 or less, high wipe durability was obtained.

Furthermore, EHPE3150 having no benzene ring has superior compatibility with a silicone compound, and therefore it has been found that it is suitable as an epoxy resin.

On the other hand, for Comparative Examples 1 to 42, the mechanical strength was insufficient as $\theta\gamma$ after wipe was less than 0.70. Silicone compounds containing one epoxy group have a degree of freedom in the siloxane main chain and tend to be segregated to the surface of the film. Therefore, it is considered that the siloxane main chain is shaved in the wipe durability test and the wipe durability is poor.

In the evaluation using the ink-jet recording head, there was no deflection even in continuous printing and high printing quality was exhibited in Examples 1 to 43. Meanwhile, for Comparative Examples 1 to 42, the deflection was observed after continuous printing.

As described above, the fluorine-based water-repellent material exhibits good water-repellency but is feared to affect the environment. On the other hand, the photosensitive resin composition according to the present embodiment exhibits good water repellency even when having no fluorine-based water-repellent material.

The technologies described in this specification have the potential to contribute to the achievement of a sustainable society, such as a decarbonized society/circular society.

Various embodiments have been described in detail above but it will be understood that the present disclosure is not limited to these embodiments and encompasses all modifications, variants, alternatives and equivalents falling within the scope of the appended claims.

## Claims

**1.** An ink-jet recording head, wherein

the ink-jet recording head has a silicone-containing film on a surface where a discharge port is provided,
when a surface of the silicone-containing film etched in a thickness direction perpendicular to the surface of the silicone-containing film using $C_{60}^+$ with an accelerating voltage of 40 kV applied thereto is subjected to a

composition analysis by a time of flight secondary ion mass spectrometry ToF-SIMS, a value of a ratio of an abundance of $SiC_3H_9^+$ at an etching time of 30 s to an abundance of $SiC_3H_9^+$ at an outermost surface (0 s) of the silicone-containing film is 0.70 or more, and
a contact angle at the outermost surface of the silicone-containing film is 80° or more.

2. The ink-jet recording head according to claim 1, wherein the contact angle is 85° or more.

3. The ink-jet recording head according to claim 1 or 2, wherein

the silicone-containing film is a cured product of a resin composition containing a silicone compound, and
the silicone compound is an alkylsiloxane resin having a structure represented by Formula (1) below:

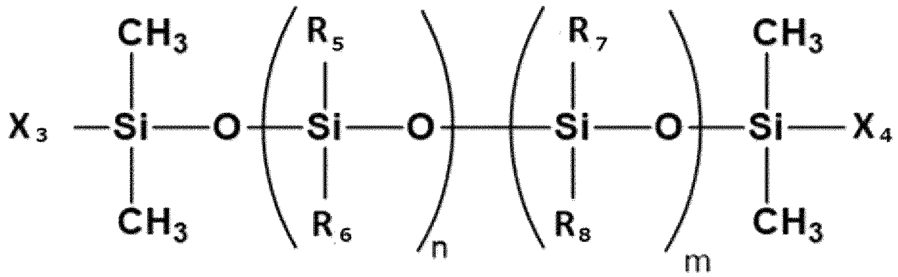
(1)

in Formula (1), $R_5$ and $R_6$ are each independently an alkyl group having 1 to 12 carbon atoms or an aryl group having 6 to 12 carbon atoms, and
at least two of $R_7$, $R_8$, $X_3$, and $X_4$ are each independently an epoxy-containing group, the others are each independently an alkyl group having 1 to 12 carbon atoms or an aryl group having 6 to 12 carbon atoms, and n + m is an integer of 1 to 60.

4. The ink-jet recording head according to claim 3, wherein the epoxy-containing group is a group having a glycidyl ether group or a group having an epoxycyclohexyl group.

5. The ink-jet recording head according to claim 3 or 4, wherein the epoxy-containing group is a 2-(3,4-epoxycyclohexyl) ethyl group.

6. The ink-jet recording head according to any one of claims 3 to 5, wherein

the resin composition contains a photopolymerization initiator, and
the photopolymerization initiator allows cationic polymerization.

7. The ink-jet recording head according to any one of claims 3 to 6, wherein the resin composition has an epoxy resin different from the alkylsiloxane resin having the structure represented by Formula (1) above.

8. The ink-jet recording head according to claim 7, wherein the epoxy resin is at least one selected from the group consisting of an epoxy resin having an alicyclic skeleton, an epoxy resin having a bisphenol skeleton, an epoxy resin having a phenol novolac skeleton, an epoxy resin having a cresol novolac skeleton, an epoxy resin having a norbornene skeleton, an epoxy resin having a terpene skeleton, an epoxy resin having a dicyclopentadiene skeleton, and an epoxy resin having an oxycyclohexane skeleton.

9. The ink-jet recording head according to claim 7 or 8, wherein an epoxy equivalent of the epoxy resin is 300 g/eq. or less.

10. The ink-jet recording head according to any one of claims 7 to 9, wherein the epoxy resin has an alicyclic epoxy resin.

Fig. 1A

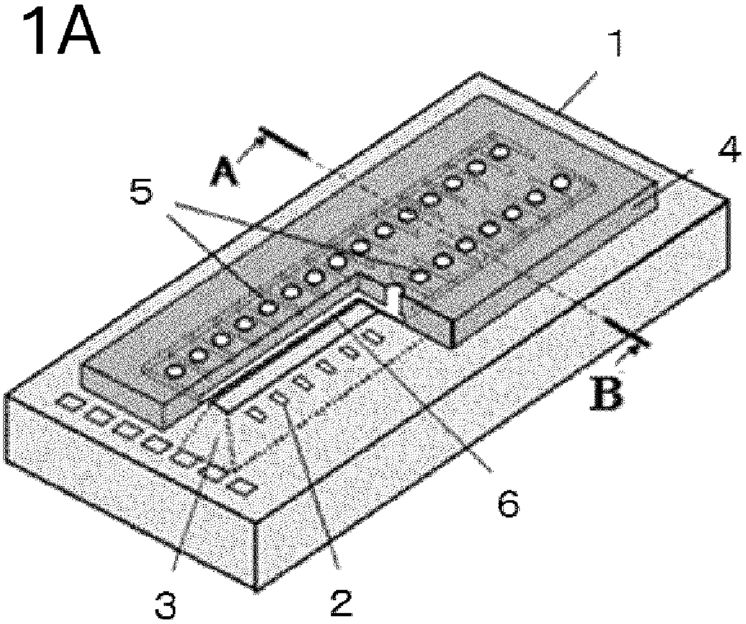


Fig. 1B

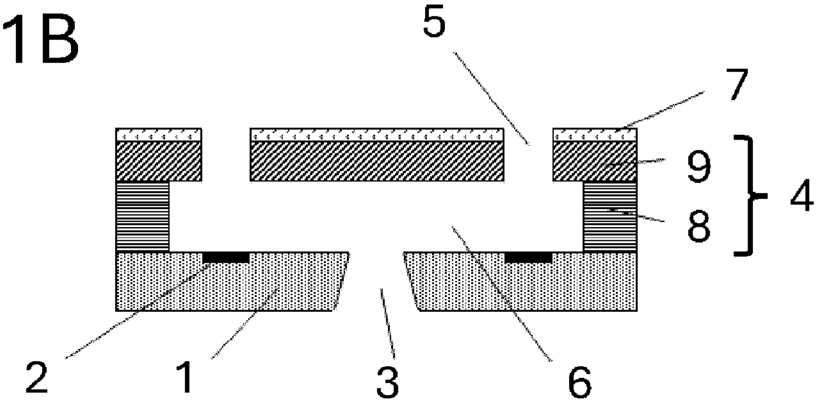

Fig. 2A

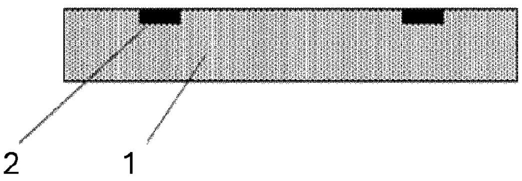


Fig. 2B

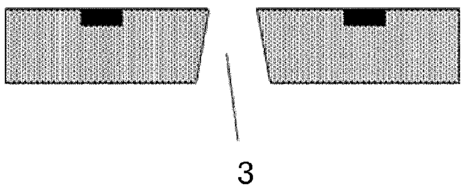


Fig. 2C

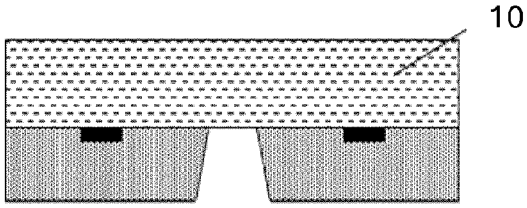


Fig. 2D

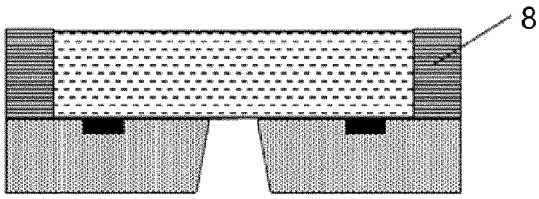


Fig. 2E

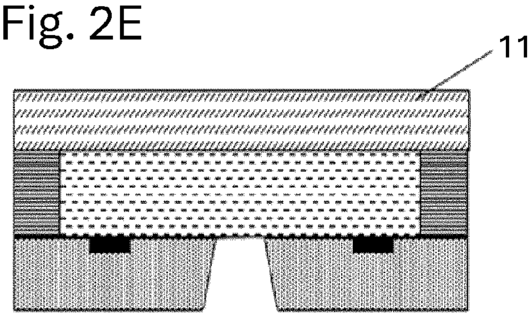


Fig. 2F

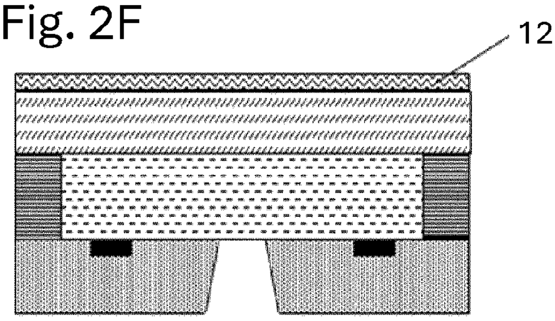


Fig. 2G

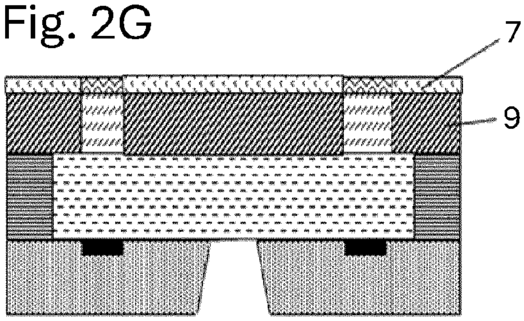


Fig. 2H

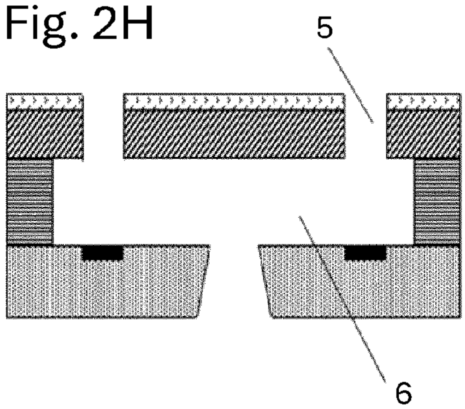

Fig. 3A

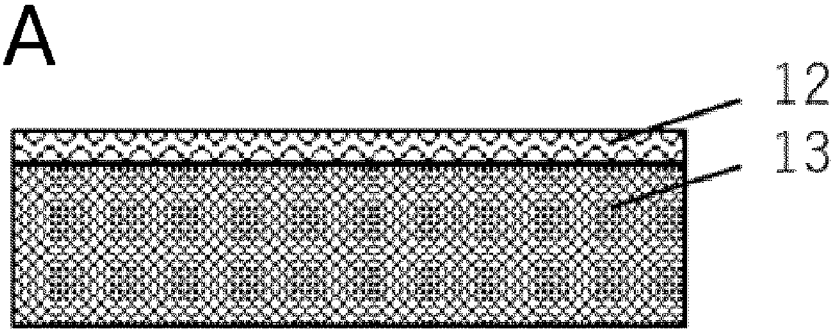


Fig. 3B

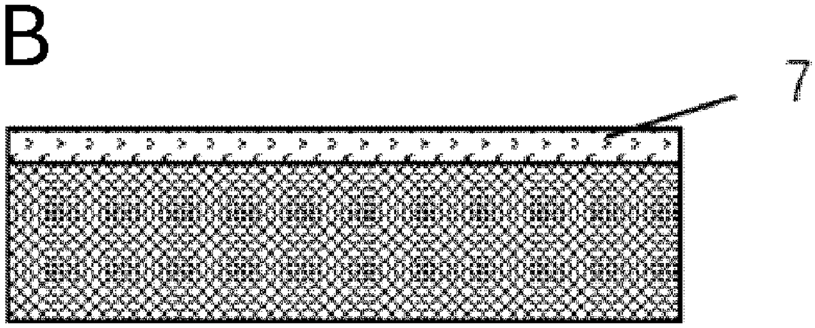

Fig. 4A

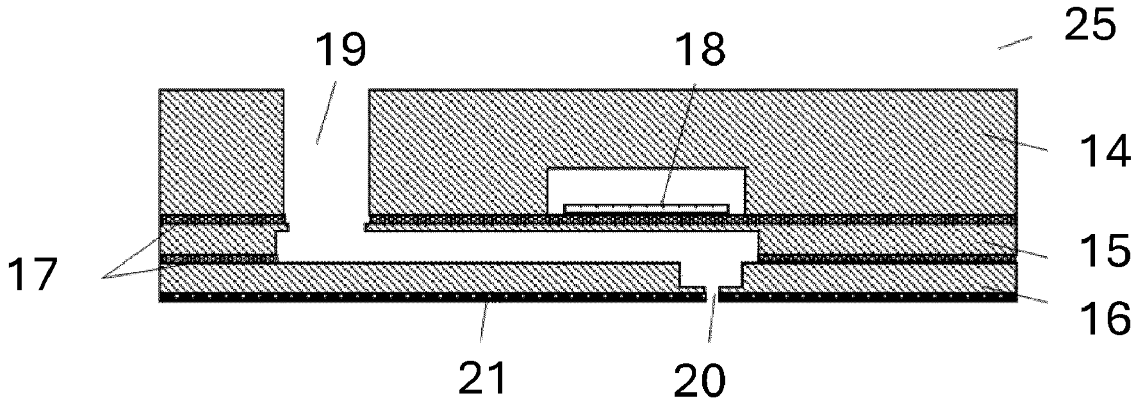


Fig. 4B

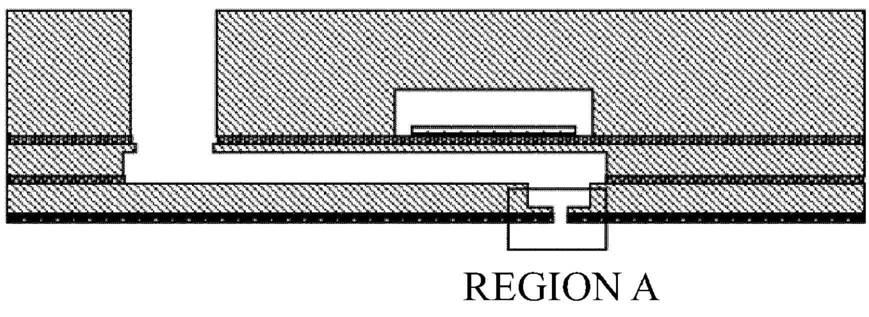

Fig. 5A

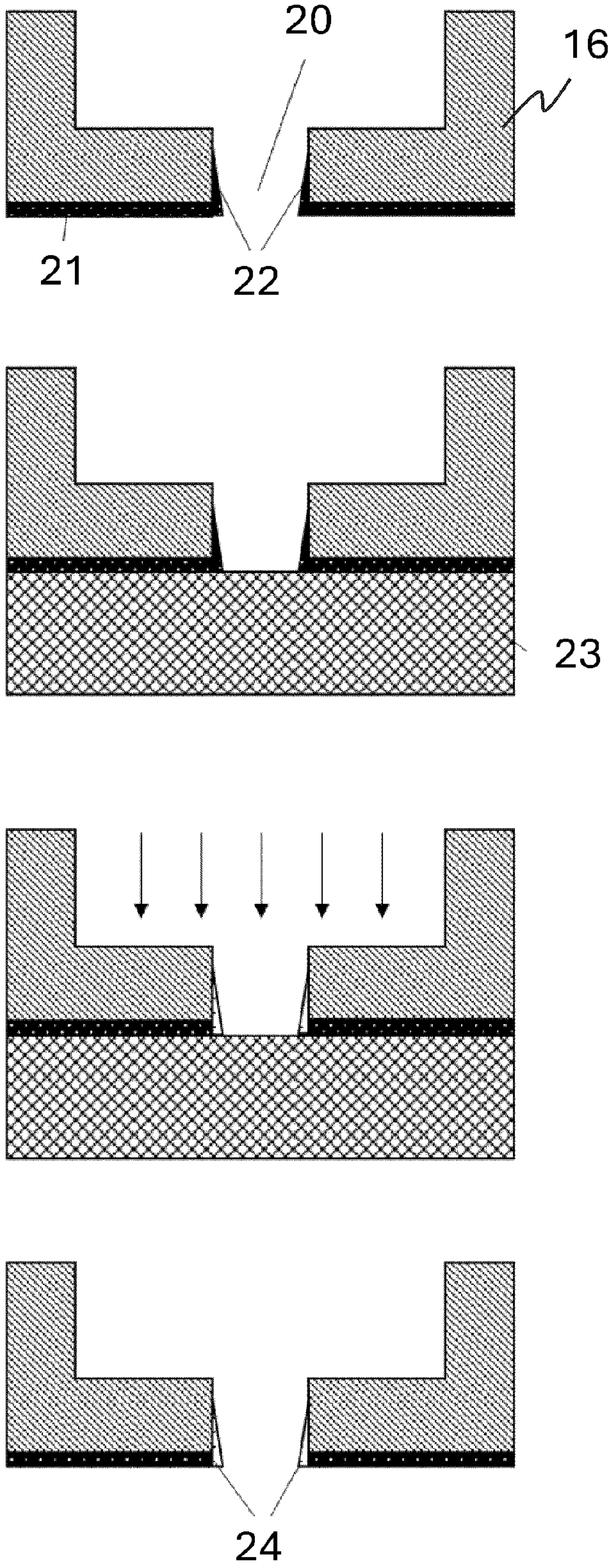


Fig. 5B



Fig. 5C

Fig. 5D

Fig. 6

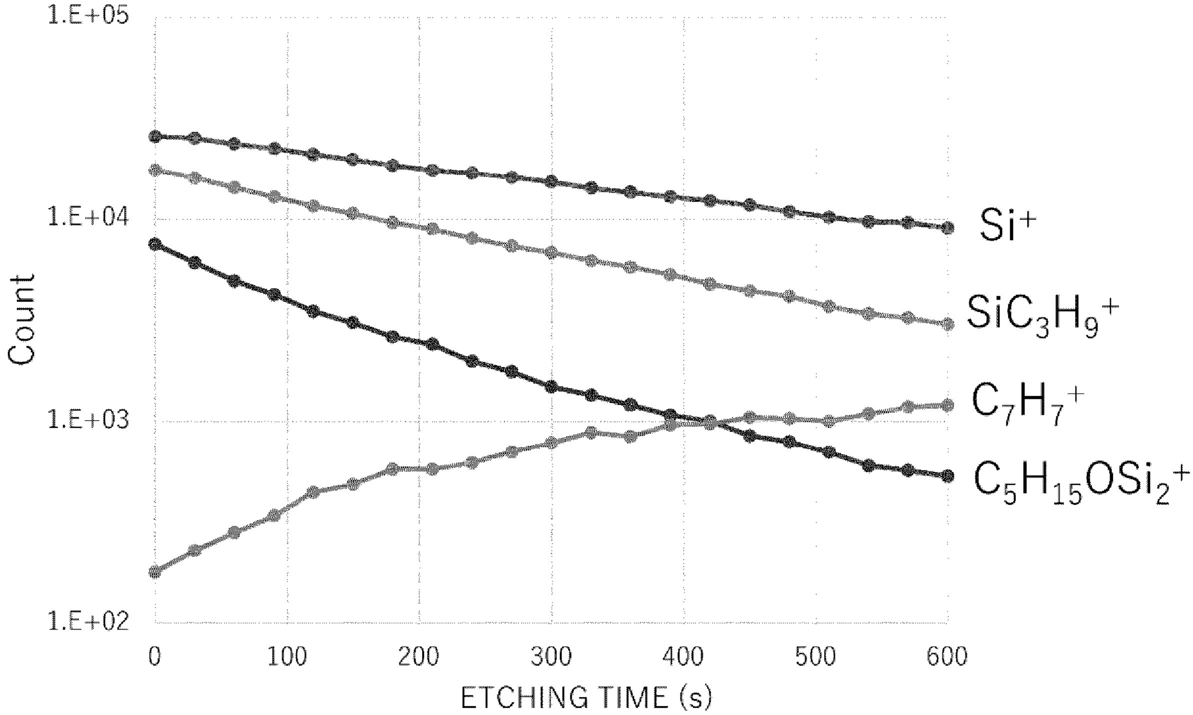
1.E+05
1.E+04
1.E+03
1.E+02
Count
0
100
200
300
400
500
600
ETCHING TIME (s)
Si+
SiC3H9+
C7H7+
C5H15OSi2+

Europäisches Patentamt
European Patent Office
Office européen des brevets

# EUROPEAN SEARCH REPORT

Application Number
EP 25 19 3969

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2001 158818 A (CANON KK) 12 June 2001 (2001-06-12) | 1,2 | INV. B41J2/16 |
| A | * figures 66,77; table 2 * | 3-10 | |
| | ----- | | |

TECHNICAL FIELDS SEARCHED (IPC)
B41J
G03F

The present search report has been drawn up for all claims

1

| Place of search | Date of completion of the search | Examiner |
|---|---|---|
| The Hague | 6 January 2026 | Bardet, Maude |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 19 3969

This annex lists the patent family members relating to the patent documents cited in the above-mentioned European search report. The members are as contained in the European Patent Office EDP file on
The European Patent Office is in no way liable for these particulars which are merely given for the purpose of information.

06-01-2026

| Patent document cited in search report | Publication date | Patent family member(s) | Publication date |
|---|---|---|---|
| JP 2001158818 A | 12-06-2001 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001158818 A